Europäisches Patentamt

European Patent Office

Office européen des brevets

(19)

(11) **EP 0 600 786 B1**

(12) **FASCICULE DE BREVET EUROPEEN**

(45) Date de publication et mention
de la délivrance du brevet:
**14.08.1996 Bulletin 1996/33**

(51) Int Cl.6: **F27D 3/00**, B64G 1/22

(21) Numéro de dépôt: **93402895.2**

(22) Date de dépôt: **30.11.1993**

(54) **Dispositif de chargement de four spatial automatique**

Automatische Ladevorrichtung für einen Ofen im Weltraum

Automatic charging device for a furnace in space

(84) Etats contractants désignés:
**DE ES GB**

(30) Priorité: **01.12.1992 FR 9214469**

(43) Date de publication de la demande:
**08.06.1994 Bulletin 1994/23**

(73) Titulaire: **SOCIETE EUROPEENNE DE
PROPULSION
F-92150 Suresnes (FR)**

(72) Inventeur: **Valentian, Dominique
F-78710 Rosny (FR)**

(74) Mandataire: **Thévenet, Jean-Bruno et al
Cabinet Beau de Loménie
158, rue de l'Université
75340 Paris Cédex 07 (FR)**

(56) Documents cités:
- **ESA BULLETIN no. 31, Août 1982, PARIS pages
34 - 45 H.HUTH 'the materials-science element of
the first spacelab payload'**
- **INSPEC / PROCEEDINGS OF THE 24TH
INTERSOCIETY ENERGY CONVERSION
ENGINEERING CONFERENCE IECEC-89 -
INSPEC NR: 3676703 vol. 2, 1989, NEW YORK
pages 895 - 903 STRUMPF . RUBLY . COOMS
'material compatibility and simulation testing....'**

## Description

### Dispositif de chargement de four spatial automatique

### Domaine de l'invention

La présente invention concerne d'une façon générale les mécanismes de commande de fours installés sur des stations spatiales ou des satellites et devant fonctionner de façon automatique pendant de longues périodes, de l'ordre de plusieurs mois jusqu'à l'intervention d'un spationaute ou la récupération du satellite.

Les fours spatiaux automatiques permettent de procéder à divers traitements en microgravité sur des échantillons placés dans des cartouches fermées de façon étanche.

A titre d'exemples de traitements dans des fours spatiaux, on peut noter la solidification orientée, notamment de semiconducteurs tels que l'arséniure de gallium, l'antimoniure et le phosphure d'indium, ou encore la solidification en phase vapeur, notamment par épitaxie, concernant par exemple du tellure de cadmium dopé au mercure.

La présente invention concerne plus particulièrement un dispositif de chargement et de déchargement de four permettant d'introduire de façon automatique dans un four, puis de retirer de celui-ci, de façon individuelle, au cours d'une mission dans l'espace sans intervention humaine, des cartouches fermées étanches préalablement préparées au sol et stockées dans un magasin disposé dans une station spatiale ou un satellite au voisinage d'un four de traitement.

### Art antérieur

On connaît déjà, notamment par la communication de R. SRINIVAS et D. SCHAEFER intitulée : "IAF-87-406 Multiple Experiment Processing Furnace (MEPF) : An Overview" effectué au 38e congrès de la Fédération Astronautique Internationale (IAF) qui s'est tenu à Brighton, GB du 10 au 17 octobre 1987, des dispositifs automatiques d'échange d'échantillons dans des fours spatiaux.

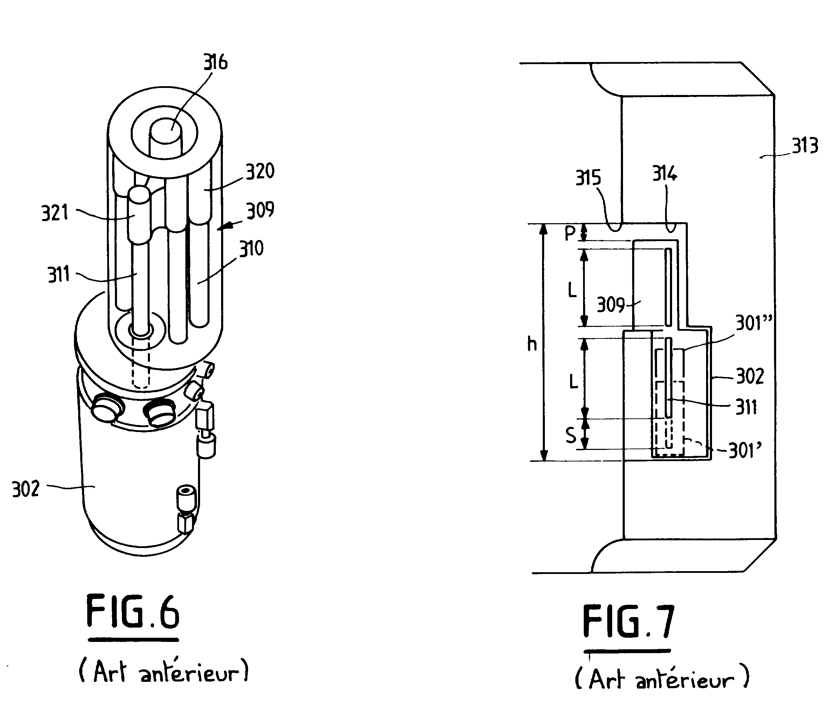

Dans de telles réalisations connues, les échantillons sont placés dans des cartouches fermées 310 elles-mêmes disposées dans des supports ou pieds de cartouches 320 montés sous la forme d'un barillet dans un magasin de stockage cylindrique 309 qui est placé dans le prolongement de l'ensemble 302 constituant une enceinte dans laquelle se trouve le four de traitement (figures 6 et 7). Le magasin de stockage 309 présente un axe de rotation parallèle à l'axe géométrique longitudinal du four, mais décalé par rapport à celui-ci de façon que, par rotation du barillet, les cartouches 310 viennent successivement dans des positions 311 qui sont alignées avec l'axe géométrique longitudinal du four. Le support 321 de la cartouche 311 destinée à être introduite dans le four est alors saisi par un mécanisme 316 assurant une translation en direction du four. Le four 301 est lui-même équipé d'un mécanisme d'entraînement en translation (non représenté sur les dessins) le long de tiges-guides afin de pouvoir soumettre l'échantillon placé dans la cartouche de travail 311 dans différentes zones de température, comme cela est requis par exemple pour réaliser une solidification.

Les fours spatiaux automatiques de l'art antérieur tels que ceux décrits dans l'article précité font ainsi appel à trois mécanismes différents pour effectuer les opérations de chargement-déchargement des cartouches ainsi que le traitement des échantillons des cartouches en position de travail, à savoir : un mécanisme d'entraînement en rotation du barillet disposé dans le magasin 309 de stockage des cartouches 310, un mécanisme 316 de translation de la cartouche 311 devant être chargée ou déchargée et un mécanisme d'entraînement en translation du four de traitement 301. Les dispositifs de chargement de four spatial automatique connus sont donc relativement complexes et délicats à réaliser, d'autant plus que la cartouche 311 contenant un échantillon à traiter, qui comporte un connecteur muni de contacts électriques pour différents signaux de mesure, doit, lorsqu'elle est en position de travail, permettre une connexion correcte de ce connecteur avec un connecteur complémentaire associé au four. La réalisation de connecteurs à enfichage automatique dans des dispositifs soumis à des translations de grande amplitude pose des problèmes d'alignement et de force d'insertion.

Les dispositifs de chargement de four de l'art antérieur du type à translation de cartouches à partir d'un magasin superposé au four conduisent également à un encombrement très important alors que les volumes disponibles sont toujours réduits dans les stations spatiales ou les satellites.

Ainsi, si l'on considère la figure 7, on voit que le montage traditionnel d'une chambre de process 302 contenant un four et de l'ensemble de chargement automatique 309 du four, dans un logement 314 formé dans la paroi 313 d'un véhicule spatial, nécessite que le logement 314 présente une hauteur totale h minimale telle que :

$$h > 2L + s + P$$

où

$L$ = longueur de la cartouche 311 ;
$s$ = course du four, par exemple pour un processus de solidification, entre des positions 301' et 301" ;
$P$ = espace supplémentaire pour permettre la manipulation du barillet 309 (de l'ordre de 10 cm environ).

En pratique, la hauteur h, qui dépend naturellement du type de four, est en général au moins de l'ordre de 1 m et l'ouverture 315 permettant l'échange de magasin 309 doit au moins être égale à L+P, soit en pratique de l'ordre de 50 à 60 cm.

## Objet et description succincte de l'invention

L'invention vise à remédier aux inconvénients précités des dispositifs de l'art antérieur et notamment à simplifier les dispositifs mécaniques de positionnement et d'échange automatique des cartouches entre un magasin de stockage et ce four de travail.

L'invention vise plus particulièrement à réaliser un dispositif de chargement-déchargement de four spatial qui soit compact, léger, simple, fiable et ne crée pas de moments cinétiques et quantités de mouvements pouvant affecter la stabilité du satellite ou de la station incorporant le dispositif.

L'invention vise encore à permettre d'effectuer des connexions électriques plus sûres entre une cartouche en position de travail et la structure de support du four de traitement.

Ces buts sont atteints grâce à un dispositif de chargement d'un four spatial automatique de traitement comportant un axe géométrique longitudinal et des moyens pour entraîner en translation de façon guidée le four le long dudit axe géométrique longitudinal, le dispositif de chargement étant disposé au voisinage du four et comprenant un barillet porte-cartouches muni d'un ensemble de pieds de cartouche dans lesquels sont montées de façon amovible des cartouches fermées étanches destinées à contenir chacune un échantillon à traiter dans ledit four spatial et disposées dans le barillet parallèlement à l'axe de rotation de celui-ci, et un mécanisme de commande d'entraînement en rotation des pieds de cartouche avec indexation, caractérisé en ce que le barillet est lui-même monté par rapport au four de telle sorte que son axe de rotation forme un angle prédéterminé $\alpha$ par rapport à l'axe géométrique longitudinal du four et en ce que chaque pied de cartouche du barillet coopère avec un mécanisme de basculement pour permettre à chaque cartouche de présenter une position de travail dans laquelle l'axe de la cartouche est incliné dudit angle prédéterminé $\alpha$ par rapport à l'axe de rotation du barillet pour être alignée avec l'axe géométrique du four.

Le mécanisme de commande d'entraînement en rotation des pieds de cartouche avec indexation et le mécanisme de basculement de pied de cartouche peuvent être constitués par un mécanisme unique.

Avantageusement, ledit angle prédéterminé $\alpha$ entre l'axe de rotation du barillet et l'axe géométrique longitudinal du four est compris entre environ 30° et 50°.

L'invention permet, vis-à-vis des systèmes existants, de réduire l'encombrement de l'ensemble four spatial et dispositif de chargement et aussi de réduire la masse de l'ensemble par la suppression d'un mécanisme. Lorsqu'une cartouche destinée à être engagée dans le four a été basculée par rapport à l'axe de rotation du barillet, l'engagement de la cartouche dans le four peut en effet être effectué par la simple translation du four.

La plus grande simplicité du système augmente la fiabilité de l'ensemble, ce qui est une caractéristique très importante pour le matériel spatial, le non-fonctionnement d'un four entraînant une perte importante et l'intervention exceptionnelle d'un spationaute représentant une dépense élevée.

On notera que le système de chargement selon l'invention respecte les contraintes de microgravité, le système de commande, quoique purement mécanique, ne produisant pas de choc de verrouillage, tandis qu'en cas de translation de cartouche, comme dans les dispositifs de l'art antérieur, il existe toujours le risque d'un choc en fin de course.

Dans le cas fréquent où les échantillons comprennent des produits très toxiques, le barillet ainsi que les mécanismes de commande d'entraînement en rotation et de basculement des pieds de cartouche sont placés à l'intérieur d'un conteneur hermétique muni d'une ouverture latérale obturable, de façon à apporter une sécurité contre d'éventuelles fuites des cartouches pendant le transport jusqu'à la mise en orbite. La porte obturant l'ouverture est ouverte sélectivement pour permettre l'inclinaison d'une cartouche pendant les opérations de traitement dans l'espace.

Le four et le barillet peuvent être installés selon différentes configurations qui sont toutes plus compactes que les systèmes pour lesquels les cartouches sont transférées dans le four par translation.

Ainsi, selon un premier agencement possible, l'axe de rotation du barillet est incliné dudit angle prédéterminé $\alpha$ par rapport à la paroi d'un véhicule spatial qui est elle-même parallèle à l'axe géométrique du four monté de façon amovible dans un logement de ladite paroi.

Selon un autre agencement possible, l'axe de rotation du barillet est parallèle à la paroi d'un véhicule spatial, tandis que l'axe géométrique du four monté de façon amovible dans un logement de ladite paroi est lui-même incliné par rapport à cette paroi.

Le montage et le démontage des cartouches dans le barillet de stockage peuvent également s'opérer de diverses manières.

Selon un mode de réalisation particulier, le barillet est disposé dans un compartiment de chargement muni d'un couvercle disposé du côté opposé aux pieds de cartouche de manière à permettre le chargement et le déchargement de l'ensemble des cartouches du côté opposé aux pieds de cartouche entre deux séquences de traitement d'un jeu de cartouches.

Selon un autre mode de réalisation particulier, le barillet est disposé dans un compartiment de chargement muni d'un couvercle disposé du côté des pieds de cartouche de manière à permettre le chargement et le déchargement de l'ensemble des cartouches à travers les pieds de cartouche entre deux séquences de traitement d'un jeu de cartouches.

Selon encore une autre réalisation particulière, le barillet est disposé dans un compartiment de chargement raccordé par des brides à une enceinte définissant une chambre de process et contenant le four ainsi que les mécanismes de commande d'entraînement en rotation et de basculement des pieds de cartouche, de manière à permettre un échange de l'ensemble du barillet entre deux séquences de traitement d'un jeu de cartouches.

La possibilité, pour une cartouche, de s'écarter d'un angle prédéterminé par rapport à l'axe de rotation du barillet permet de mettre en oeuvre des moyens de connexion électrique plus simples et plus fiables entre une cartouche en position de travail et le support du four de traitement.

Ainsi, selon une caractéristique particulière de la présente invention, chaque pied de cartouche comprend une interface essentiellement plane de positionnement mécanique et de connexion électrique adaptée pour coopérer avec une interface complémentaire unique essentiellement plane de positionnement mécanique et de connexion électrique disposée sur des moyens de support desdits moyens d'entraînement en translation du four.

A titre d'exemple, lesdites interfaces de positionnement mécanique et de connexion électrique comprennent des éléments de centrage complémentaires en forme de vé.

De façon plus particulière, lesdites interfaces de positionnement mécanique et de connexion électrique comprennent des premiers contacts électriques de forte intensité pour le passage du courant nécessaire au processus lors du traitement d'échantillons et des seconds contacts électriques de faible intensité pour le passage des signaux électriques de mesure.

Pour certaines applications, l'invention permet de mettre en oeuvre facilement un dispositif de préchauffage des cartouches qui s'étend de façon statique autour d'au moins une partie du barillet cylindrique de part et d'autre d'une ouverture permettant le basculement d'une cartouche en position de travail.

Le système selon l'invention, en permettant un rangement compact des cartouches, assure une bonne tenue aux vibrations lors du lancement dans l'espace.

Afin d'améliorer la tenue aux vibrations, selon un mode particulier de réalisation, le dispositif de chargement du four comprend un dispositif amortisseur de vibrations comprenant une roue centrale disposée au centre du barillet au voisinage des extrémités des cartouches opposées aux pieds de cartouche et munie d'empreintes formées à sa périphérie pour recevoir les extrémités des cartouches et un cerclage extérieur statique qui entoure la roue centrale à l'extérieur des cartouches et présente une interruption pour permettre le basculement d'une cartouche en position de travail.

Le mécanisme de commande d'entraînement en rotation des pieds de cartouche avec indexation et le mécanisme de basculement de pied de cartouche peuvent être réalisés de diverses manières.

Selon un mode particulier de réalisation, le mécanisme de commande d'entraînement en rotation des pieds de cartouche avec indexation comprend un moteur électrique qui coopère avec un réducteur et un dispositif à croix de Malte agissant sur la partie inférieure des pieds de cartouche.

De façon plus particulière, selon un mode de réalisation possible, le mécanisme de commande d'entraînement en rotation des pieds de cartouche avec indexation comprend un moteur électrique qui entraîne un doigt de commande de rotation agissant sur des gorges formées dans les pieds de cartouche et une came coopérant avec des alvéoles formées dans les pieds de cartouche pour assurer un verrouillage à chaque indexation.

Le moteur électrique peut présenter soit un axe parallèle à l'axe de rotation du barillet, soit un axe perpendiculaire et concourant à l'axe de rotation du barillet.

Le mécanisme de basculement de pieds de cartouche comprend une courte chaîne cinématique dérivée du mécanisme de commande d'entraînement en rotation des pieds de cartouche.

De façon plus particulière, selon un premier mode de réalisation possible, le mécanisme de basculement de pied de cartouche comprend un organe formant came qui est entraîné à partir d'un moteur électrique constituant l'organe initiateur du mécanisme de commande d'entraînement en rotation des pieds de cartouche, et qui coopère avec des parties supérieures profilées des pieds de cartouche, chaque pied de cartouche coopérant en outre avec un ressort de rappel dans une position de repos parallèlement à l'axe de rotation du barillet.

Selon un autre mode de réalisation possible, le mécanisme de basculement de pieds de cartouche comprend un organe en forme de tiroir qui coopère avec des parties supérieures profilées des pieds de cartouche et présente un mouvement de va-et-vient induit par un moteur électrique constituant l'organe initiateur du mécanisme de commande d'entraînement en rotation des pieds de cartouche.

Selon encore un autre mode de réalisation, le mécanisme de basculement de pied de cartouche comprend une genouillère agissant sur les parties supérieures des pieds de cartouche et coopérant avec un moteur électrique.

Brève description des dessins

D'autres caractéristiques et avantages de l'invention ressortiront de la description suivante de modes particuliers de réalisation donnés à titre d'exemples non limitatifs, en référence aux dessins annexés, sur lesquels :

-    la figure 1 est une vue schématique en coupe axiale d'un four spatial automatique équipé d'un dispositif d'échange de cartouches, conforme à l'invention, dans lequel un lot de cartouches est introduit latéralement,

- la figure 2 est une vue schématique en coupe axiale d'un four spatial automatique équipé d'un dispositif d'échange de cartouches, conforme à l'invention, dans lequel un lot de cartouches est introduit axialement,
- la figure 3 est une vue schématique en coupe axiale d'un four spatial à montage vertical associé à un dispositif d'échange de cartouches incliné conforme à l'invention,
- la figure 4 est une vue schématique en coupe axiale d'un premier exemple de four spatial à montage oblique associé à un dispositif d'échange de cartouches vertical conforme à l'invention,
- la figure 5 est une vue schématique en coupe axiale d'un deuxième exemple de four spatial à montage oblique associé à un dispositif d'échange de cartouches vertical conforme à l'invention au sein d'une chambre de process pouvant basculer pour permettre l'introduction d'un lot de cartouches,
- la figure 6 est une vue en perspective d'un four spatial associé à un dispositif d'échange de cartouches selon l'art antérieur,
- la figure 7 est une vue schématique en coupe axiale d'un four spatial vertical associé à un dispositif connu d'échange de cartouches placé dans le prolongement du four,
- la figure 8 est une vue en perspective montrant une opération de chargement d'un four spatial à partir d'un dispositif de chargement de four selon l'invention,
- la figure 9 est une vue en perspective montrant un dispositif de chargement de four selon l'invention placé dans une enceinte munie d'une ouverture obturable,
- les figures 10A et 10B montrent un exemple de système de commande d'ouverture d'une porte d'obturation pouvant être associée à l'enceinte de la figure 9, respectivement en position fermée et en position ouverte,
- la figure 10C montre en perspective un détail du système de commande d'ouverture des figures 10A et 10B,
- Les figures 11A et 11B montrent schématiquement un exemple de porte d'obturation coulissante respectivement dans des positions fermée et ouverte, adaptable à l'enceinte de la figure 9,
- les figures 12A et 12B montrent schématiquement un exemple de porte d'obturation pivotante respectivement dans des positions fermée et ouverte, adaptable à l'enceinte de la figure 2,
- la figure 13 montre en perspective la mise en oeuvre d'un dispositif d'amortissement dans un dispositif d'échange de cartouches selon l'invention,
- la figure 14 montre en perspective un mode particulier de réalisation d'un mécanisme de commande d'entraînement en rotation de barillet et de basculement de cartouche avec un moteur électrique à axe parallèle à celui du barillet,

- la figure 15 montre en perspective un mode particulier de réalisation d'un mécanisme de commande d'entraînement en rotation de barillet et de basculement de cartouche avec un moteur électrique à axe perpendiculaire et concourant à celui du barillet,
- les figures 16A, 16B et 16C sont des vues de dessus montrant trois phases successives d'une partie du mécanisme de commande de la figure 14,
- les figures 17 et 18 sont des vues de dessus et en élévation d'un autre mode particulier de réalisation d'un mécanisme de commande d'entraînement en rotation de barillet et de basculement de cartouche, du type à tiroir,
- les figures 19 et 20 sont des vues de dessus et en perspective avec éclatement d'une partie du mécanisme des figures 17 et 18,
- la figure 21 est une vue en perspective d'un dispositif de connexion électrique applicable au dispositif d'échange de cartouches selon l'invention,
- les figures 22 et 23 sont des vues en élévation montrant deux positions différentes d'un autre exemple de mécanisme de commande de basculement de cartouche applicable au dispositif d'échange de cartouches selon l'invention,
- les figures 24 et 25 sont des vues de détail en demi-perspective montrant deux modes particuliers de réalisation de brides de raccordement d'un compartiment de chargement de cartouches selon l'invention,
- la figure 26 est une vue en perspective d'un autre exemple de mécanisme de commande de basculement de cartouche applicable au dispositif d'échange de cartouches selon l'invention,
- la figure 27 est une vue en perspective d'une partie seulement du mécanisme de la figure 26,
- la figure 28 est une vue schématique en coupe partielle montrant diverses positions d'un pied de cartouche coopérant avec le mécanisme de la figure 26,
- la figure 29 est une vue de côté du mécanisme de la figure 26,
- les figures 30A et 30B montrent un détail de montage d'un pied de cartouche avec le mécanisme des figures 26 à 29,
- les figures 31A et 31B montrent une variante de réalisation du détail de montage des figures 30A et 30B, et
- la figure 32 montre une vue en perspective d'une enceinte de dispositif d'échange de cartouches selon l'invention, dans laquelle sont incorporés des moyens de préchauffage de cartouche.

Description détaillée de modes particuliers de réalisation

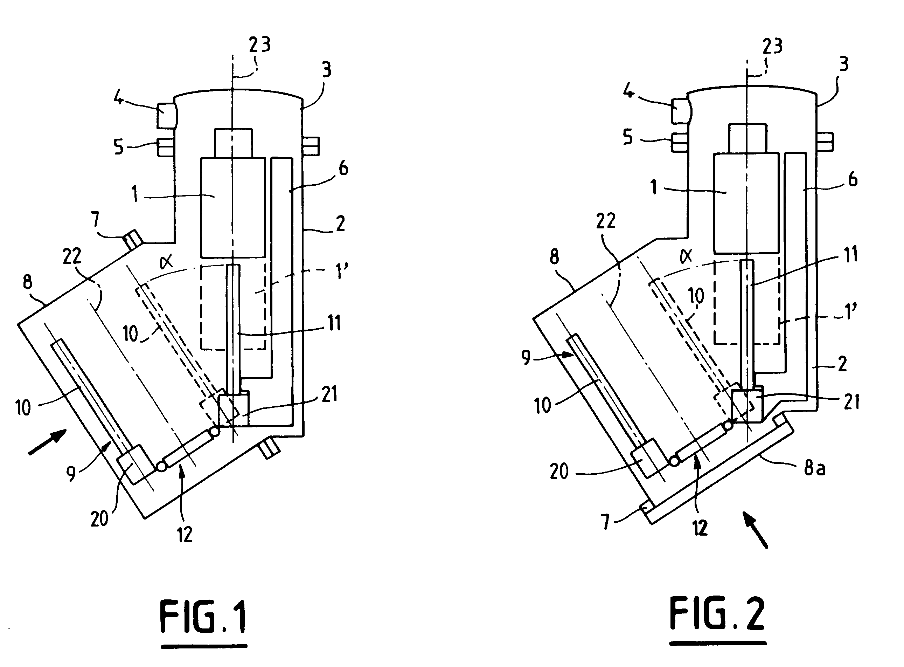

On considerera tout d'abord la figure 1 qui montre une enceinte 2 de four spatial définissant une chambre de process destinée à être installée dans un logement au sein d'un satellite ou d'une station spatiale.

La référence 3 désigne une partie démontable de l'enceinte 2, qui est munie d'organes 4 de traversée étanche et se trouve raccordée au corps principal de l'enceinte 2 par une liaison à brides 5.

Un four 1 proprement dit est introduit dans l'enceinte 2 lorsque la partie 3 est démontée, et se trouve monté sur un dispositif de support 6, qui peut par exemple comporter des colonnettes ou une table-guide, de telle manière que le four 1 peut se déplacer en translation selon son axe géométrique longitudinal 23 afin de venir dans la position 1' représentée en pointillé sur la figure 1. Le mécanisme de translation du four 1 le long du dispositif de support 6 peut lui-même être classique.

Un compartiment 8 contenant un lot de cartouches 10 et un mécanisme de chargement et de déchargement des cartouches 10 est également rapporté sur le corps principal de l'enceinte 2, latéralement, et se trouve relié à l'enceinte 2 par une liaison à brides 7.

Conformément à l'invention, le lot de cartouches 10 est monté à l'intérieur du compartiment 8 dans des pieds de cartouche 20 qui sont montés de façon à constituer un barillet 9. Selon une caractéristique essentielle, l'axe de rotation 22 du barillet 9, auquel sont parallèles les cartouches 10 en position de repos stockées dans le compartiment 8, forme un angle prédéterminé avec l'axe géométrique longitudinal 23 du four 1.

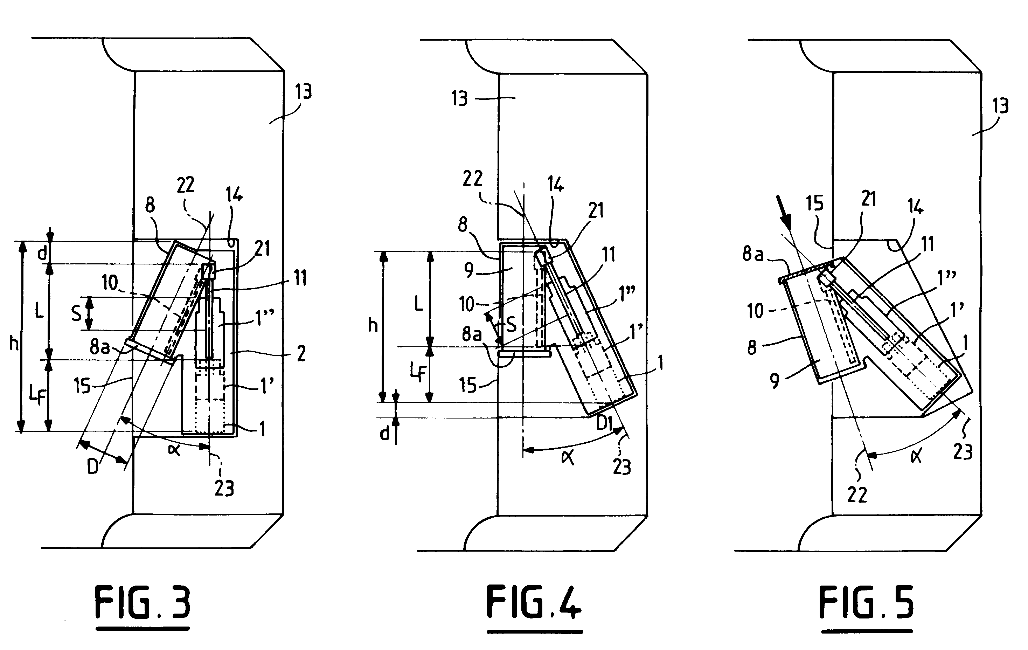

Cet angle prédéterminé α, repéré sur les figures 3 à 5, peut être avantageusement compris entre environ 30° et 50°.

Grâce à la disposition particulière du compartiment 8 de stockage des cartouches 10 à proximité immédiate du four 1, à côté de celui-ci, l'enceinte 2 peut être très compacte et, surtout, chaque cartouche 10 peut être introduite très facilement dans le four 1, par un simple mouvement de basculement du pied de cartouche 20 autour d'un axe perpendiculaire à l'axe 22 du barillet 9 et à l'axe géométrique 23 du four 1. Le mécanisme 12 d'entraînement en rotation du barillet 9 avec indexation, pour amener une nouvelle cartouche 10 au voisinage du four 1, coopère avec des moyens assurant la commande du basculement de la cartouche 10 d'un angle égal audit angle prédéterminé a pour amener le pied de cartouche 20 et la cartouche 10 dans une position de travail. Le pied de cartouche et la cartouche en position de travail sont désignés respectivement par les références 21 et 11 sur les dessins. Lorsque, par un simple mouvement de basculement déclenché par le mécanisme 12 d'entraînement en rotation du barillet, la cartouche 11 se trouve alignée avec l'axe 23 du four 1, il suffit de positionner la cartouche 11 dans la position longitudinale souhaitée par rapport au four 1 par une simple translation du four 1 le long de son support 6. Sur la figure 1, on a représenté en pointillé une position 1' dans laquelle la cartouche 11 est engagée pratiquement totalement dans le four.

La figure 2 représente une simple variante de réalisation dans laquelle le corps principal de l'enceinte 2 comprend également le compartiment 8 contenant le barillet 9 et le lot de cartouches 10. Dans ce cas, un couvercle 8a est disposé à la partie inférieure du compartiment 8 pour permettre d'introduire ou de retirer le lot de cartouches 10 et le barillet 9 axialement.

Les figures 3 à 5 montrent des exemples d'agencement, dans un véhicule spatial, d'une enceinte 2 contenant un four 1, un compartiment 8 de stockage de cartouches 10 ainsi qu'un mécanisme de translation de four et un mécanisme d'entraînement en rotation du barillet et de basculement de cartouche (non représentés), l'ensemble constituant une chambre de process.

L'enceinte 2 est montée à travers une ouverture 15 dans un logement 14 d'une paroi 13 de véhicule spatial.

Sur la figure 3, le four 1 est placé verticalement, c'est-à-dire parallèlement à la paroi 13, tandis que le compartiment 8 et le barillet qu'il contient sont inclinés d'un angle prédéterminé α par rapport à la paroi 13.

Dans le montage de la figure 3, la hauteur totale h de l'enceinte 2 doit être telle que :

$$h > L + L_f + d$$

avec $d = D \sin \alpha$

où

$L$ = longueur de cartouche
$L_f$ = longueur du four, soit de l'ordre de 80 % de la longueur L en pratique
$D$ = diamètre du compartiment 8 contenant le barillet 9
$\alpha$ = angle d'inclinaison du barillet.

On constate que la hauteur minimale h dans le cas du montage de la figure 3 est de l'ordre de 20 % plus faible que la hauteur minimale requise dans un montage traditionnel tel que celui de la figure 7. En particulier, la course s du four 1 entre ses positions extrêmes 1' et 1" lors du traitement d'un échantillon, par exemple pour réaliser une solidification, n'intervient plus dans la détermination de la hauteur minimale du logement 14.

Sur les figures 4 et 5, le compartiment 8 et le barillet 9 qu'il contient sont placés verticalement, c'est-à-dire parallèlement à la paroi 13 du véhicule spatial, tandis que le four 1 est incliné d'un angle α par rapport à l'axe 22 du barillet 9.

Dans le cas des montages des figures 4 et 5, la hauteur h totale de l'enceinte 2 et du logement 14 doit être telle que :

$$h > (L + L_f).\cos \alpha + d$$

avec $d = D_1.\sin \alpha$
où

$L$ = longueur de cartouche
$L_f$ = longueur du four, soit $\approx 0,8\,L$
$D_1$ = rayon du corps principal de l'enceinte 2 contenant le four 1

α = angle d'inclinaison du four 1 par rapport au barillet 9.

Dans le cas des figures 4 et 5, la hauteur minimale h peut être de l'ordre de 30 % plus faible que la hauteur minimale requise dans un montage traditionnel tel que celui de la figure 7 et, là encore, le gain en hauteur peut être considéré comme supérieur à la course s du four 1.

A titre d'exemple pour les paramètres des montages des figures 3 à 5 et 7, des valeurs typiques peuvent être :

| L = 400 mm | | P = 100 mm |
|---|---|---|
| $L_f$ = 300 mm | | D = 200 mm |
| s = 120 mm | | $D_1$ = 150 mm |
| | α = 30°. | |

Dans ce cas, les valeurs minimales pour la hauteur h sont respectivement, $h_1$ = 800 mm pour le montage de la figure 3, $h_2$ = 680 mm pour le montage des figures 4 et 5 et $h_3$ = 1 020 mm pour le montage de la figure 7.

Le mode de chargement ou de déchargement des cartouches 10 dans le barillet 9 et le compartiment 8 entre deux missions peut être très varié. Ainsi, sur les modes de réalisation des figures 3 et 4, les cartouches 10 peuvent être installées dans le compartiment 8 ou retirées de celui-ci en enlevant un couvercle 8a situé du côté opposé aux pieds de cartouche, de sorte que les cartouches peuvent être manipulées sans traverser les pieds de cartouche.

En revanche, dans le mode de réalisation de la figure 5, dans lequel l'ensemble de l'enceinte 5 peut basculer par rapport au logement 14, ou dans le cas de la figure 2, le couvercle 8a est situé du côté des pieds de cartouche 20, de sorte que le chargement et le déchargement d'un lot de cartouches 10 s'effectuent à travers les pieds de cartouche 20 entre deux séquences de traitement.

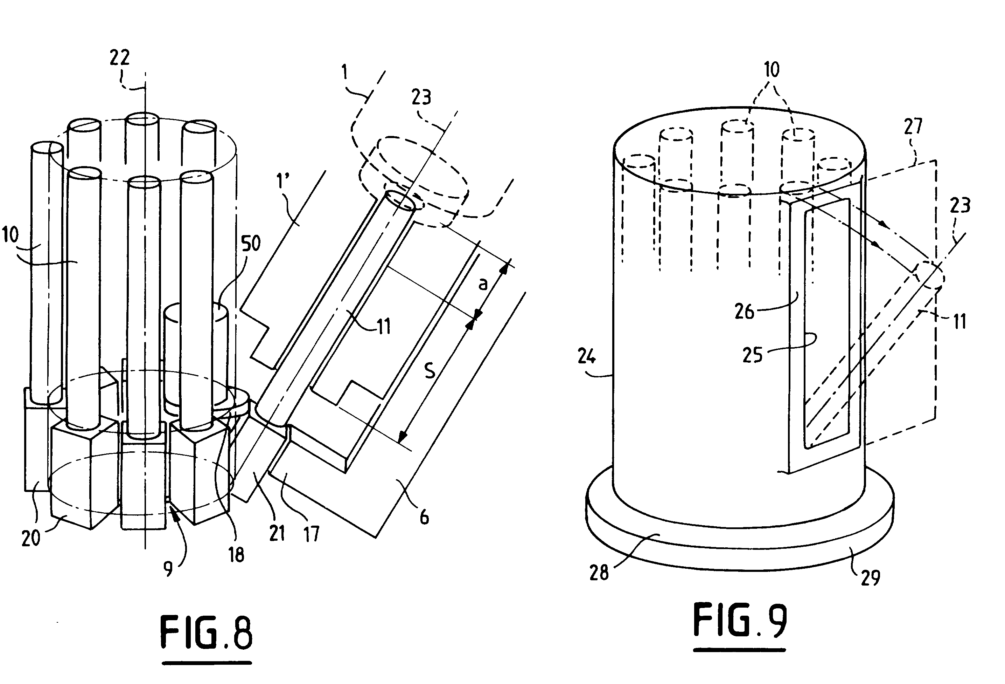

La figure 8 montre un dispositif d'échange de cartouche selon l'invention, dans une position telle qu'une cartouche à traiter est montrée dans sa position de travail 11 alignée avec l'axe 23 du four 1.

Le barillet 9 ou plateau tournant porte un ensemble de par exemple 6 à 32 pieds de cartouche 20 dans lesquels sont engagées de façon amovible les cartouches 10 contenant des échantillons à traiter. Les cartouches 10 sont verrouillées sur les pieds de cartouche 20 par des moyens de verrouillage classiques, par exemple à billes, non représentés sur le dessin. La liaison entre une cartouche 10 et son pied de support 20 comprend en outre un connecteur électrique pour permettre une liaison avec les capteurs de mesure incorporés à la cartouche.

Un moteur électrique unique 50 commande l'entraînement du mécanisme de mise en rotation du barillet 9. Lorsqu'une cartouche à traiter stockée dans le barillet 9 arrive à proximité du plan défini par l'axe de rotation 22 du barillet 9 et l'axe longitudinal 23 du four 1, le mécanisme de mise en rotation du barillet 9, auquel sont associés des moyens de basculement de cartouche 18, provoque automatiquement l'inclinaison du pied 21 de la cartouche à traiter 11 dans la position de traitement représentée sur la figure 8, l'axe de la cartouche étant confondu avec l'axe 23 du four 1.

L'exactitude du positionnement peut être définie par des surfaces ajustées, telles que des portions complémentaires en vé, disposées respectivement sur le pied 21 de la cartouche à traiter et sur l'extrémité 17 du support 6 sur lequel est monté le mécanisme de translation du four.

Des exemples de mécanisme de commande de rotation du barillet 9 et de basculement des pieds de cartouche 20 seront donnés plus loin dans la description.

Lorsqu'une cartouche 11 est en position de traitement, un connecteur électrique placé sur le pied de cartouche 21 est automatiquement mis en contact avec un connecteur électrique correspondant placé sur l'extrémité 17 du support 6. Toutefois, à titre de variante, il est également possible d'associer à chaque cartouche un câble souple relié à un contacteur tournant ayant même axe que le barillet 9 et coopérant avec le connecteur électrique placé sur l'extrémité 17 du support 6.

Lorsqu'une cartouche à traiter 11 est basculée par action du mécanisme de basculement sur le pied de cartouche 21, le four 1 est dans la position reculée représentée en pointillé sur la figure 8. Le mécanisme de translation du four, qui peut lui-même être classique, provoque une première course _a_ qui permet d'enfourner partiellement dans le four 1 la cartouche à traiter 11. Cette course _a_ peut être typiquement de 100 à 200 mm. Dans le cas d'un traitement correspondant à la solidification orientée d'un échantillon, le four 1 est chauffé pour provoquer le début de la fusion du matériau contenu dans la cartouche 11. Le four 1 descend alors selon la course s, qui peut être par exemple de l'ordre de 100 à 200 mm, jusqu'à la position 1' représentée en traits pleins sur la figure 8, ce qui entraîne la fusion du matériau à fondre. Le four remonte ensuite de sa position 1' à la position définie par la course s, ce qui entraîne la solidification orientée du matériau. Le four est ensuite refroidi et ramené à la position 1 en traits discontinus de la figure 8 avec la course supplémentaire _a_ permettant le retrait de la cartouche 11 qui est ramenée en position parallèle à l'axe 22 du barillet par le basculement du pied de cartouche 21. Après une nouvelle rotation partielle du barillet 9 amenant une autre cartouche 10 au voisinage du plan défini par les axes 22 et 23, le processus de basculement et traitement peut recommencer avec cette autre cartouche.

On notera que, dans le cas d'un four spatial, tous les différents mouvements des cartouches et du four sont très lents et ont ainsi de très faibles répercussions sur l'attitude du véhicule spatial dans lequel est embarqué le four. La lenteur des mouvements en apesanteur, ajoutée au fait que les centres de gravité des organes du dispositif d'échange de cartouche se déplacent très peu, permet de réduire les contraintes auxquelles sont soumis les organes mécaniques, ce qui, outre l'accroissement de fiabilité, permet de réduire la masse de ces différents organes et de la source d'énergie commandant le mécanisme et par suite d'effectuer une économie sur l'opération de mise en orbite.

La figure 9 montre un mode particulier de réalisation dans lequel le barillet 9 est enfermé dans un compartiment hermétique 24 contenant l'ensemble des pieds de cartouche 20 et des cartouches 10. Une ouverture latérale oblongue 25, dont la ligne médiane correspond au plan défini par l'axe de rotation du barillet et l'axe 23 du four, permet le passage d'une cartouche à traiter 11 en position basculée. L'ouverture 25 est fermée sélectivement par un volet mobile 27 portant sur la surface d'étanchéité 26 entourant l'ouverture 25. Lors du transport, le volet 27 est fermé et empêche que des produits toxiques contenus dans des cartouches ne se répandent à l'extérieur en cas d'incident. Lorsque le barillet 9 est chargé dans la chambre de process 2 (figures 1 à 5), le volet 27 est ouvert pour permettre la sortie des cartouches. L'étanchéité entre la chambre de process et le barillet 9 est obtenue par une bride 29 portant par exemple un joint torique 28.

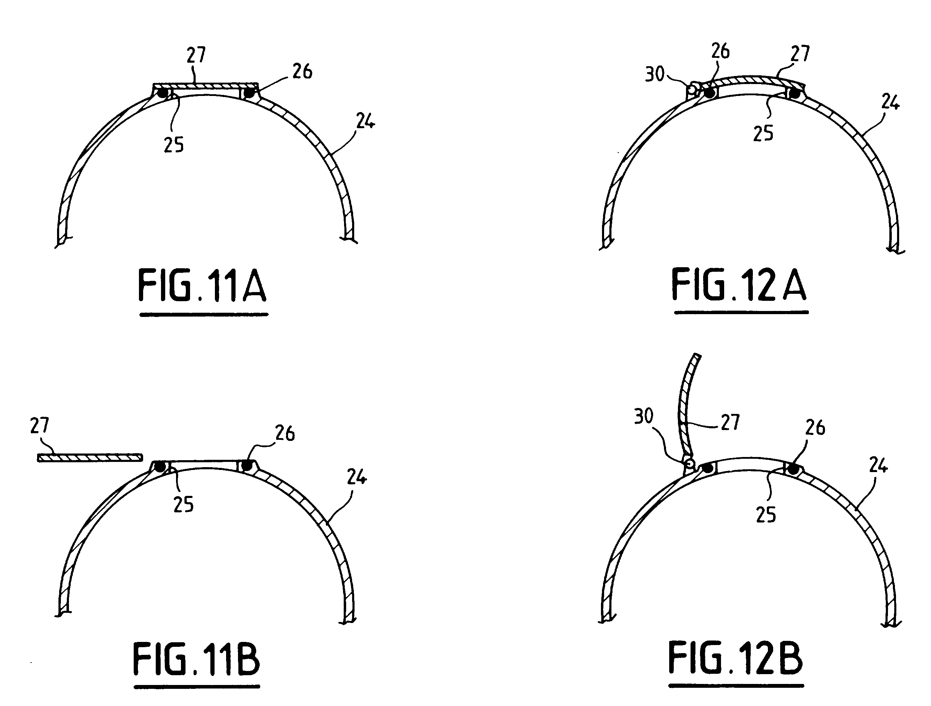

Le volet 27 peut opérer par coulissement (figures 11A et 11B) ou par pivotement (figures 12A et 12B). Dans le cas d'un volet 27 pivotant autour d'une articulation 30, un ressort de rappel est avantageusement associé à cette articulation 30 pour ramener le volet 27 en position de fermeture.

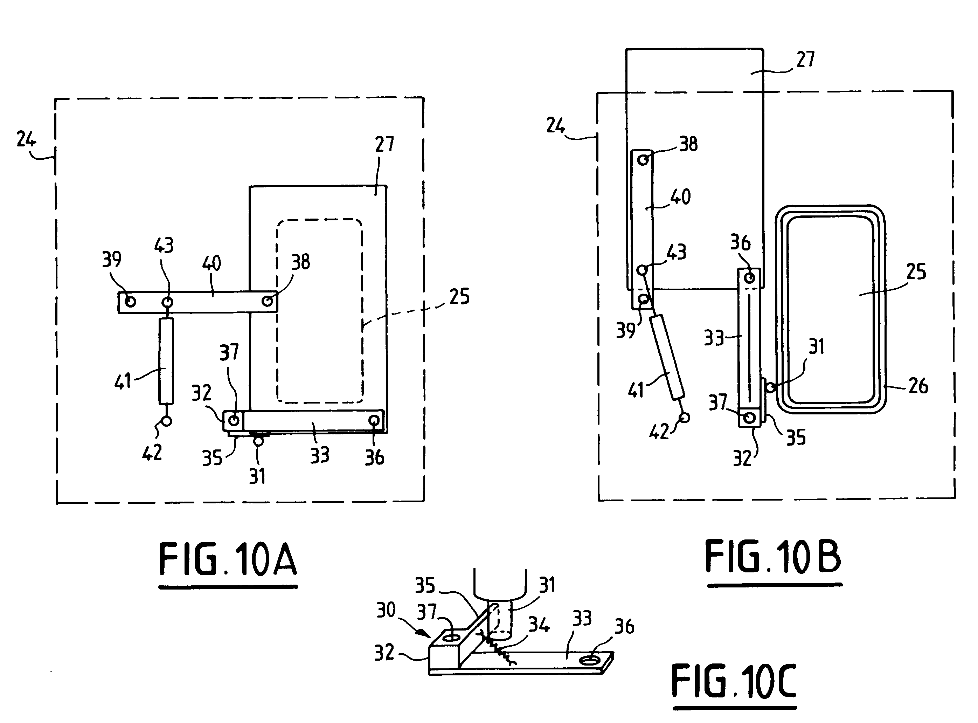

Les figures 10A à 10C montrent un exemple de mécanisme de commande d'ouverture d'un volet translatable 27 monté sur un compartiment hermétique 24 contenant un barillet 9.

Sur les figures 10A et 10B, le compartiment 24 de la figure 9 est représenté de façon symbolique par un cadre en traits interrompus. La figure 10A représente le compartiment 24 avec le volet 27 en position fermée juste avant un chargement dans l'enceinte hermétique 2 (figures 1 à 5) constituant la chambre de process. Un galet 31 solidaire du support de four 6 (figure 2) vient en contact avec le mécanisme d'ouverture du volet 27 par translation lors de la mise en place du compartiment 24 dans l'enceinte 2. La figure 10B représente le compartiment 24 après chargement dans l'enceinte 2, avec le volet 27 ouvert par action du galet 31 sur le mécanisme d'ouverture du volet 27.

Le mécanisme d'ouverture de volet représenté sur les figures 10A et 10B comporte deux tiges 33, respectivement 40 d'un parallélogramme articulées sur le volet 27 (articulations 36, respectivement 38) et sur le compartiment étanche 24 (articulations 37, respectivement 39). La tige 40 coopère avec un ressort de rappel 41 fixé sur le compartiment (référence 42) et sur la tige 40 (référence 43). La tige 33 est elle-même commandée par un doigt de commande 30 coopérant avec le galet 31. Le doigt de commande 30 peut comprendre un corps 32 articulé autour de l'articulation 37, relié par un ressort 34 à la tige 33 et prolongé par une tige 35 venant en contact avec le galet 31 (voir la figure 10C représentant le doigt de commande 30 en position intermédiaire entre les positions des figures 10A et 10B).

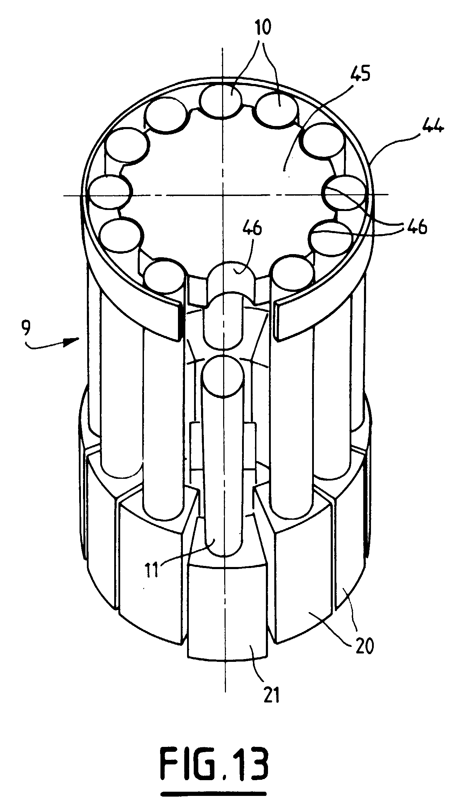

La figure 13 montre un dispositif amortisseur qui peut être installé pour empêcher l'apparition de vibrations dans le barillet 9 lors du transport. Une roue centrale 45 garnie de matériaux élastiques et entraînée en rotation par le mécanisme d'entraînement en rotation du barillet 9 est disposée entre les cartouches 10, du côté opposé aux pieds de cartouche 20. Des empreintes en forme de logements cylindriques concaves 46 sont formées à la périphérie de la roue 45 pour recevoir l'extrémité des cartouches 10 qui sont par ailleurs en contact avec une bande cylindrique 44 statique extérieure située dans le même plan radial que la roue 45. La bande cylindrique 44 formant un cerclage extérieur est interrompue dans la zone où s'opère le basculement d'une cartouche 11 devant venir en position de travail.

On décrira maintenant de façon plus détaillée divers exemples de mécanismes de commande de la rotation du barillet et de l'inclinaison d'une cartouche en position de travail.

Conformément à l'invention, il est mis en oeuvre un ensemble tournant de commande unique qui est mû par un moteur électrique et agit successivement sur tous les pieds de cartouche 20.

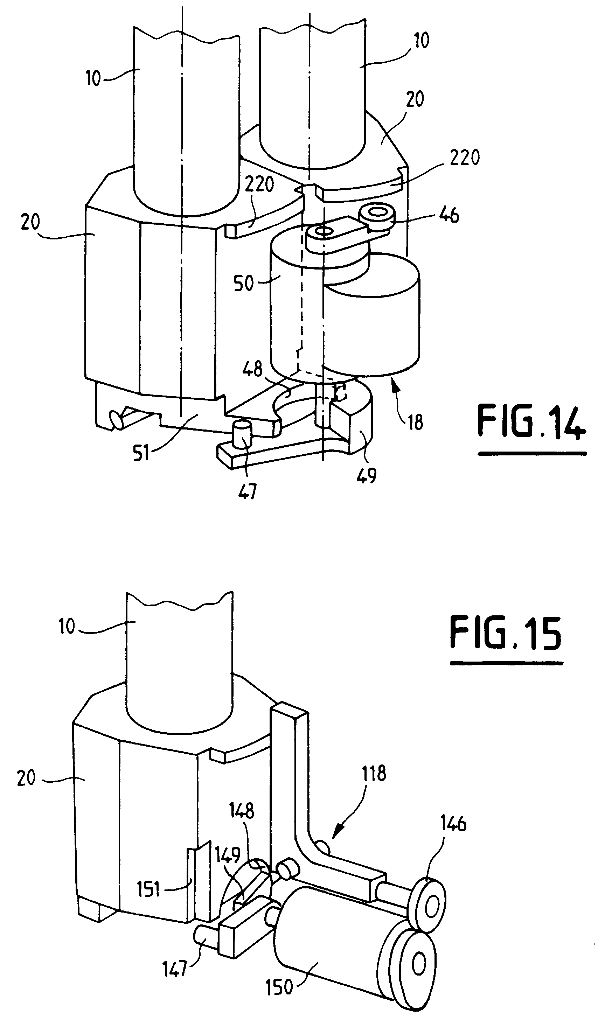

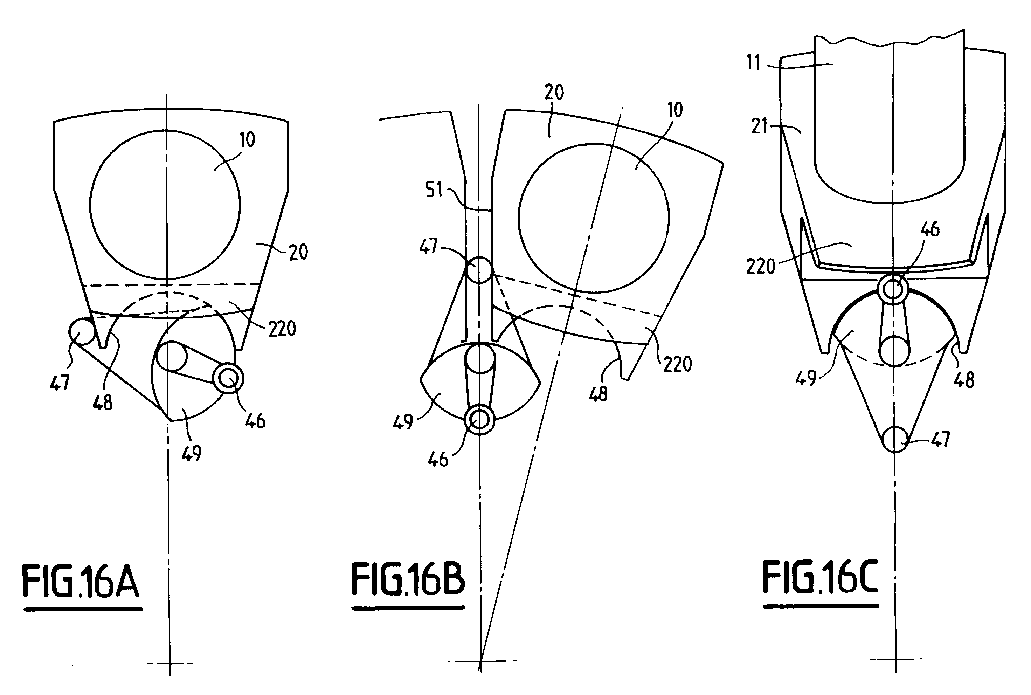

La figure 14 et les figures 16A à 16C montrent un mécanisme 18 de commande de rotation de barillet et de verrouillage dans les positions de travail successives, qui est du type à croix de Malte.

Le moteur électrique 50 entraîne en rotation un organe comprenant un doigt 47 et une came 49. Le doigt 47 sert à l'entraînement en rotation des pieds de cartouche 20 et vient s'engager dans des gorges 51 formées à la base des pieds de cartouche 20. Lorsque le doigt 47 sort des gorges 51 (figure 16C), la came 49 en forme de secteur circulaire montée sur le plateau d'entraînement du doigt 47 bloque le pied de cartouche 21 de la cartouche 11 placée en position de travail. La came 49 assurant le verrouillage en position de travail coopère avec une alvéole 48 qui est formée dans le pied de cartouche 20 et peut posséder un profil torique dont l'axe est l'axe de rotation de la cartouche Ceci permet à la came de verrouillage 49 de reste en contact permanent avec l'alvéole 48 durant l'inclinaison de la cartouche et d'assurer sa fonction quelle que soit l'inclinaison du pied de cartouche 20.

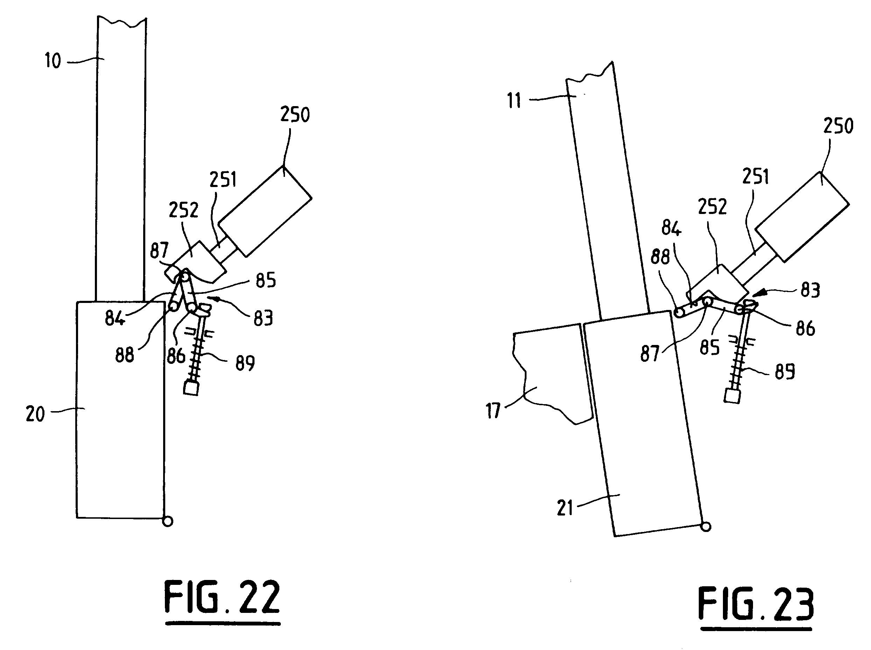

La commande de l'inclinaison d'un pied de cartouche 20 en position de travail 21 est effectuée par une courte chaîne cinématique dont l'organe initiateur est solidaire de l'ensemble tournant comprenant le doigt 47 et la came 49. L'organe initiateur peut être une came, un levier ou un commutateur électrique qui agit sur la chaîne cinématique grâce à un électroaimant ou à un moteur 250 (ce dernier cas correspondant au mode de réalisation des figures 22 et 23 qui sera décrit plus loin).

Sur le mode de réalisation des figures 16A à 16C et de la figure 14, une came à galet 46 est entraînée directement par le moteur 50 et coopère avec des portions profilées 220 formées à la partie supérieure des pieds de cartouche 20. Lorsque le doigt 47 a échappé d'une gorge 51 et que la came 49 a commencé de coopérer avec la gorge 48 d'un nouveau pied de cartouche devant venir en position de travail, la rotation des pieds de cartouche 20 est interrompue, mais, par la continuation de la rotation du moteur 50, la came 46 agissant sur une portion profilée 220 formée au sommet du pied de cartouche 21 provoque l'inclinaison de l'axe de la cartouche 11 qui est ainsi amenée en position de travail (figure 16C). Le contact entre la came à galet 46 et la portion profilée 220 est assuré par un ressort de rappel (non visible sur les figures 16A à 16C), dont la force est faible de manière à limiter les microaccélérations susceptibles de se produire en microgravité.

Dans la séquence représentée en vue de dessus sur les figures 16A à 16C, la figure 16A correspond au moment où le doigt 47 commence à entraîner une cartouche 20 et à provoquer la rotation d'ensemble du barillet, la figure 16B correspond au moment où la cartouche 20 de la figure 16A et la cartouche suivante sont en position intermédiaire et la figure 16C montre la cartouche 21 adjacente à la cartouche 20 de la figure 16A qui est parvenue en position de travail et se trouve verrouillée à sa partie inférieure par la came 49, tandis que la came à galet 46 a provoqué l'inclinaison du pied de cartouche 21.

La figure 15 montre un mécanisme 118 de commande de rotation selon une variante de réalisation dans laquelle le moteur électrique de commande 150 possède non pas un axe vertical, c'est-à-dire parallèle à l'axe de rotation du barillet, comme le moteur 50 de la figure 14, mais un axe horizontal concourant à l'axe de rotation du barillet. Les éléments 146 à 151 de la figure 15 présentent des fonctions correspondant à celles des éléments 46 à 51 de la figure 14. Sur la figure 15, la croix de Malte est située dans un plan vertical. La came 146, située à l'extrémité de l'arbre du moteur 150 qui est opposée à celle qui assure l'entraînement du doigt 147 coopérant avec la gorge verticale 151 et de la came 149 coopérant avec la gorge 148, provoque l'inclinaison du pied de cartouche 20 par un renvoi de sonnette.

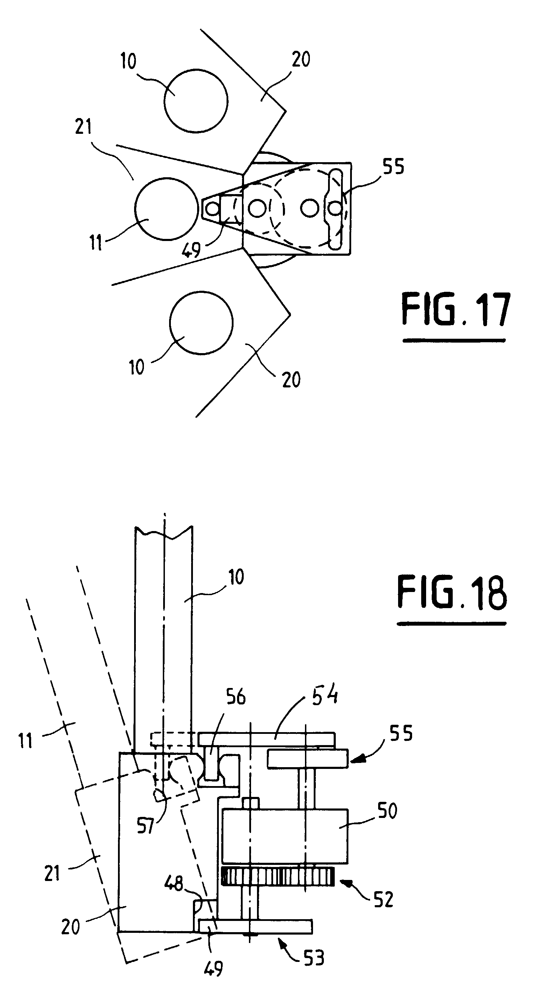

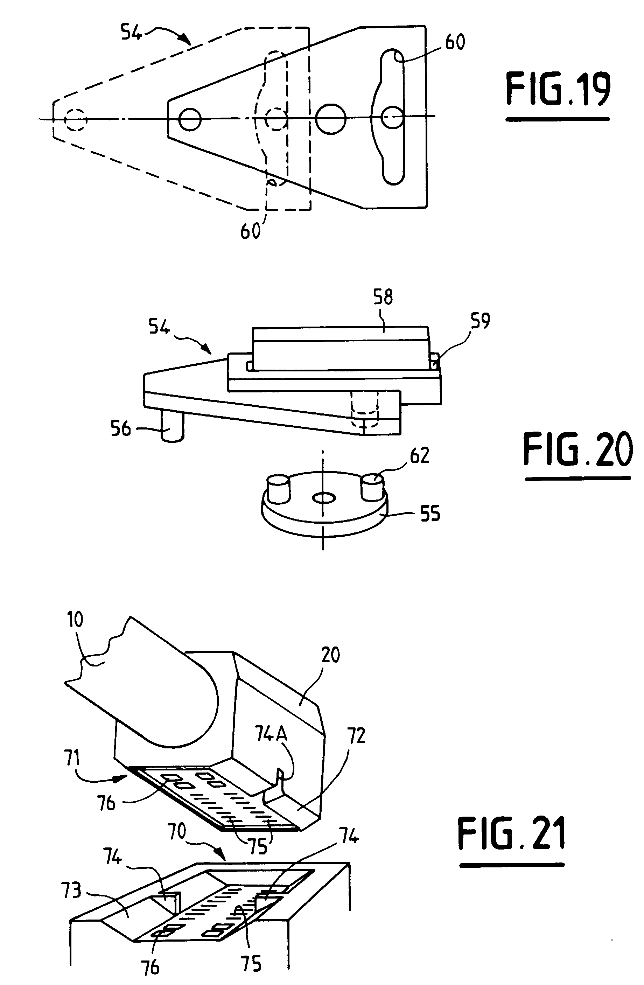

Les figures 17 à 20 correspondent à une variante de réalisation du mécanisme de commande de rotation et d'inclinaison des figures 14 et 16A à 16C. Dans le mode de réalisation des figures 17 à 20, la croix de Malte inférieure 53 entraînée par le moteur électrique 50 par l'intermédiaire d'un réducteur 52 peut être tout à fait semblable à celle décrite en référence à la figure 14. En revanche, dans le cas des figures 17 à 20, l'inclinaison d'un pied de cartouche 20 est provoquée non pas par un système à came et ressort, mais par un tiroir 54 qui accompagne le mouvement du pied de cartouche 20. Le tiroir 54 comprend essentiellement un plateau muni d'une lumière transversale profilée 60 recevant un doigt excentré 62 formé sur un plateau 55 entraîné par le moteur électrique 50 du côté opposé à la croix de Malte 53. Le tiroir 54 présente par ailleurs à sa partie terminale située en regard du pied de cartouche 20 un doigt 56 coopérant avec une gorge 57 du pied de cartouche 20 pour provoquer l'inclinaison de celui-ci (figures 18 et 20). Le tiroir 54 peut en outre présenter à sa partie supérieure une gorge 59 de réception d'un guide 58 (figure 20).

Les figures 22 et 23 montrent encore un autre mode de réalisation de mécanisme d'inclinaison de cartouche agissant sur un pied de cartouche 20. Dans ce cas, un moteur électrique 250 commandé par des contacts dont la fermeture est synchronisée avec la rotation du barillet pour provoquer de façon sélective l'inclinaison d'une cartouche entraîne une vis 251 agissant sur un activateur 252 pour provoquer l'inclinaison d'un pied de cartouche à l'aide d'un mécanisme à genouillère 83. Le mécanisme à genouillère comprend des biellettes 84, 85 articulées autour d'axes 86, 87, 88 et un ressort de rappel 89. La figure 22 représente une cartouche 10 en position de stockage avec l'activateur 252 rétracté et la genouillère 83 repliée, tandis que la figure 23 représente une cartouche 11 en position de travail avec l'activateur 252 déployé, la genouillère 83 verrouillée et le ressort de rappel 89 comprimé.

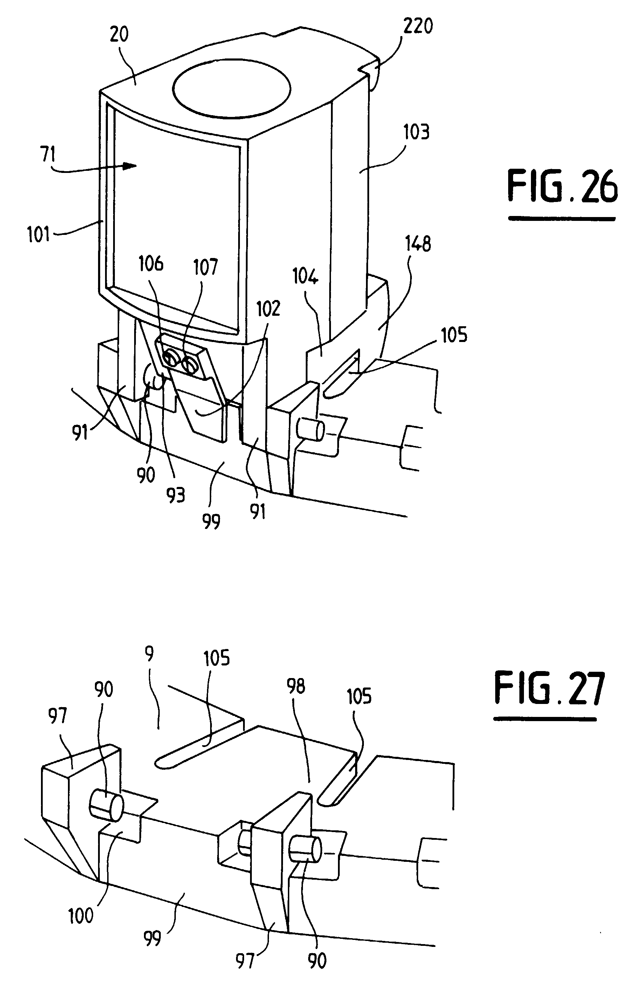

Les figures 26 à 29 montrent un mode particulier de réalisation de pied de cartouche 20 destiné à coopérer avec un mécanisme de commande de rotation de barillet 9 et d'inclinaison de cartouche du type de celui décrit en référence aux figures 14 et 16A à 16C et particulièrement adapté pour recevoir un connecteur électrique tel que celui qui sera décrit en référence à la figure 21.

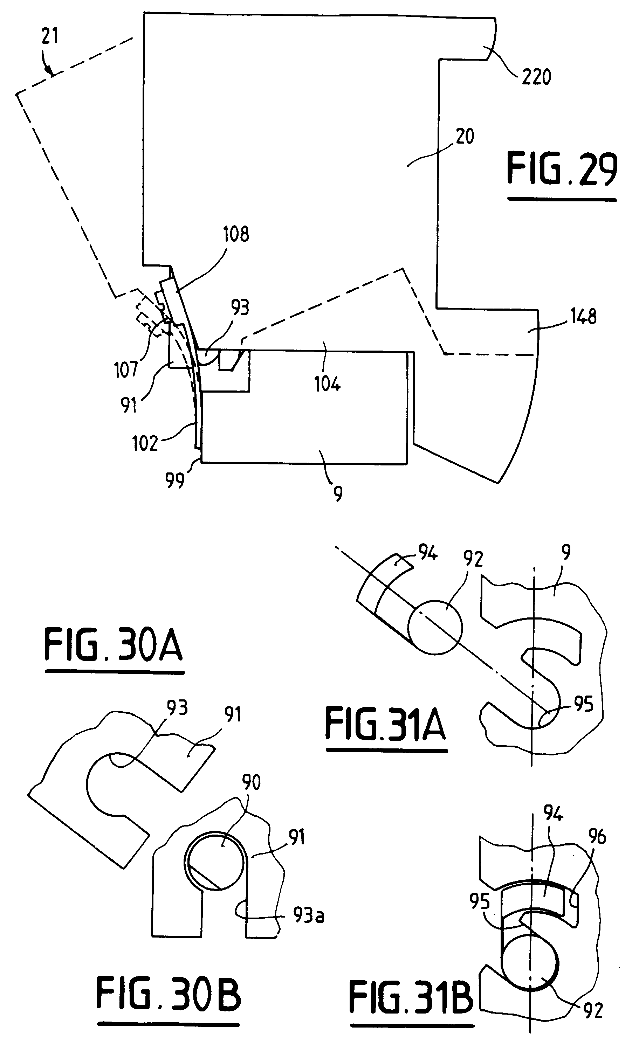

La figure 26 montre un support de cartouche 20 monté de façon articulée sur un barillet 9. Le pied de cartouche comprend à sa partie avant deux pattes latérales 91 munies chacune d'un logement 93 ouvert par une fente de sortie 93a (détail des figures 30A et 30B) pour s'engager sur des tourillons 90 montés sur des pièces 97 qui coopèrent avec les pattes 91 pour assurer le centrage latéral du pied de cartouche 20. Les pièces 97 sont rapportées sur le barillet 9 proprement dit en forme de couronne qui présente une face supérieure 98 d'appui des pieds de cartouche 20 et comprend des encoches radiales 105 formées du côté intérieur pour jouer le rôle des encoches 51 de la figure 14 et recevoir le doigt du mécanisme de commande de rotation. Des usinages 100 sont formés dans le barillet 9 pour permettre le passage des pattes 91 des pieds de cartouche 20 et le montage des tourillons 90. La face frontale 99 du barillet 9 sert de face d'appui pour des ressorts de rappel 102 à lame fixés de façon amovible par des vis 106, 107 sur une face d'appui inclinée 108 située à l'avant des pieds de cartouche 20 et servant à donner une précontrainte au ressort 102 (figure 29).

Les figures 26, 28 et 29 montrent la réalisation d'une came torique 148 jouant le rôle de l'alvéole 48 de la figure 14 et pouvant coopérer avec une came de forme adaptée correspondant à la came 49 de la figure 14.

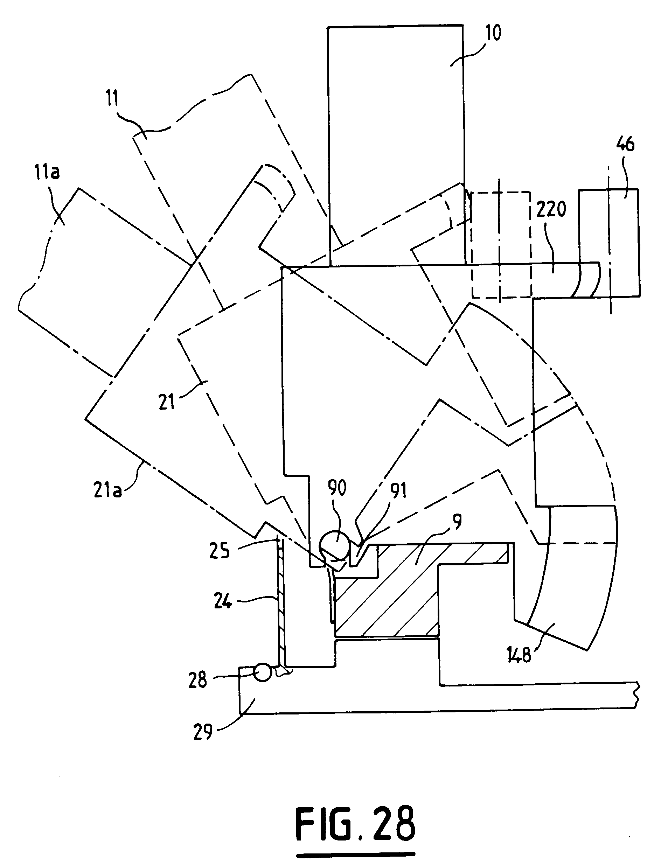

Les figures 28 et 29 montrent un pied de cartouche en position de repos (référence 20) ainsi qu'en position de travail (référence 21 et traits discontinus). La partie supérieure arrière 220 des pieds de cartouche 20 coopère avec une came 46 de commande d'inclinaison comme dans le cas de la figure 14.

La figure 28 montre en outre la position 11a, 21a d'une cartouche et de son pied de cartouche lors d'un chargement ou d'une extraction à travers l'ouverture 25 du compartiment de stockage 24.

Les figures 30A et 30B montrent une version de base dans laquelle les tourillons 90 sont formés sur le barillet 9. Toutefois, à titre de variante, illustrée sur les figures 31A et 31B, on a représenté un tourillon 92 formé sur le pied de cartouche 20 et coopérant avec un logement ouvert 95 de réception de tourillon formé sur le barillet 9. Dans ce cas, une portion incurvée supplémentaire 94 est formée dans la patte 90 du pied de cartouche 20 pour s'engager dans un logement correspondant 96 formé dans le barillet 9 et servant de guide.

Si l'on considère à nouveau la figure 26, on voit qu'un pied de cartouche comprend des faces latérales 103 en saillie permettant aux différents pieds de cartouche d'être en appui les uns contre les autres, et des parties inférieures 104 de face latérale en retrait pour permettre l'appui du doigt de commande de rotation. Un connecteur plat 71 est par ailleurs disposé sur la face frontale de chaque pied de cartouche 20 à l'intérieur d'un cadre de protection 101 qui forme, avec la paroi du compartiment hermétique 24 (figures 9 et 28), une protection contre la pollution des connecteurs des cartouches stockées en cas d'incident dans le four.

La figure 21 montre un exemple de connecteur électrique plat 71 formé sur un pied de cartouche 20 et coopérant avec un connecteur 70 formé sur le support 6 du mécanisme de translation du four.

Chacun des connecteurs 71, 70 comprend des éléments de centrage latéral complémentaires en vé 72 respectivement 73, au moins un élément de centrage axial 74 respectivement 74A, des contacts électriques de faible intensité 75 et des contacts électriques de plus forte intensité 76. Les connecteurs électriques 70, 71 ne sont engagés l'un avec l'autre que lorsque le pied de cartouche 20 est placé en position basculée. Les contacts 75, 76 peuvent être réalisés par exemple par des surfaces métallisées sur circuit imprimé pour le connecteur 71 et par des cils flexibles pour le connecteur 70.

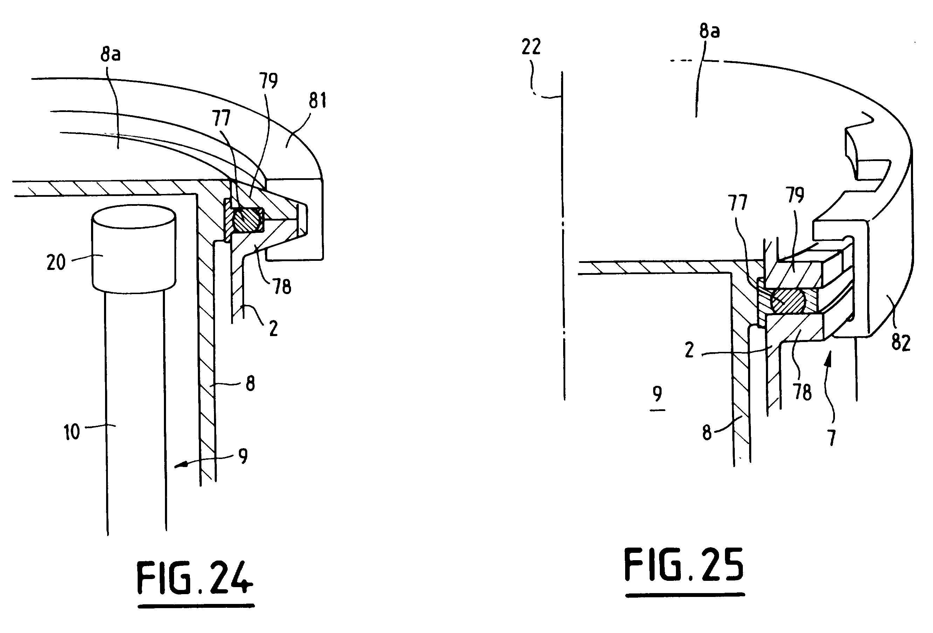

Les figures 24 et 25 montrent deux détails de réalisation de brides à démontage rapide pour un compartiment hermétique 8 destiné à être monté dans une enceinte 2 (figure 2) avec possibilité d'échange du barillet complet.

La figure 24 montre des brides 79 et 78 du compartiment 8 et de l'enceinte 2 qui enserrent un joint torique 77 et sont réunies par une sangle 81.

La figure 25 montre des brides 79 et 78 de type autoclave ou filet interrompu retenues par un organe 82 de type baïonnette.

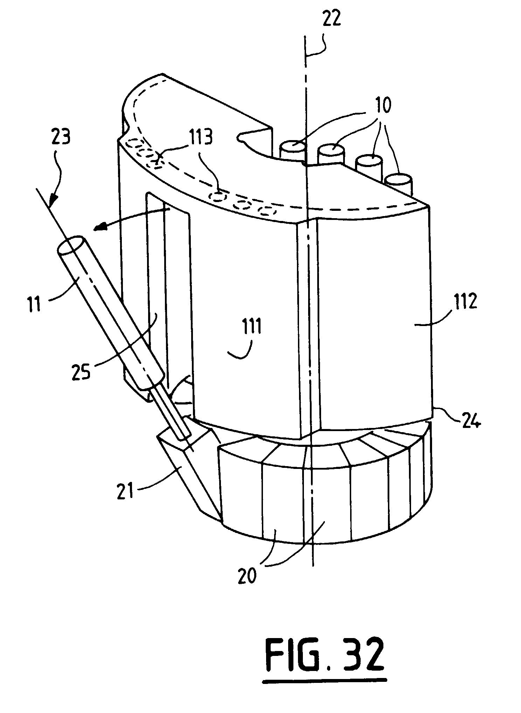

La figure 32 montre une enceinte hermétique 24 qui, selon un mode particulier de réalisation, contient un dispositif 111 de préchauffage avec des éléments chauffants 113 disposés de part et d'autre de l'ouverture 25 prévue pour le chargement et le déchargement d'une cartouche 11. Le dispositif de préchauffage assure un réchauffage progressif de la cartouche à traiter avant son introduction dans le four puis un refroidissement progressif après traitement. L'enceinte 24 comprend ainsi une zone à gradient 112 dans les parties éloignées de l'ouverture 25 et une zone isotherme 111 de part et d'autre de l'ouverture 25.

Dans les mécanismes selon la présente invention, les axes de rotation et surfaces de translation comportent des éléments de lubrification sèche adaptés à l'apesanteur et aux températures ambiantes. Ces éléments peuvent comprendre par exemple des revêtements de surface en nitrure de titane ou carbure de titane. Les roulements peuvent être lubrifiés au plomb ou au bisulfure de molybdène par exemple.

## Revendications

1. Dispositif de chargement d'un four spatial automatique de traitement (1) comportant un axe géométrique longitudinal (23) et des moyens (6) pour entraîner en translation de façon guidée le four (1) le long dudit axe géométrique longitudinal (23), le dispositif de chargement étant disposé au voisinage du four (1) et comprenant un barillet (9) porte-cartouches muni d'un ensemble de pieds de cartouche (20) dans lesquels sont montées de façon amovible des cartouches (10) fermées étanches destinées à contenir chacune un échantillon à traiter dans ledit four spatial (1) et disposées dans le barillet (9) parallèlement à l'axe de rotation (22) de celui-ci, et un mécanisme (12) de commande d'entraînement en rotation des pieds de cartouche avec indexation, caractérisé en ce que le barillet (9) est lui-même monté par rapport au four (1), de telle sorte que son axe de rotation (22) forme un angle prédéterminé a par rapport à l'axe géométrique (23) longitudinal du four (1) et en ce que chaque pied de cartouche (20) du barillet (9) coopère avec un mécanisme de basculement pour permettre à chaque cartouche de présenter une position de travail (11) dans laquelle l'axe de la cartouche est incliné dudit angle prédéterminé a par rapport à l'axe de rotation (22) du barillet (9) pour être alignée avec l'axe géométrique (23) du four (1).

2. Dispositif selon la revendication 1, caractérisé en ce que le mécanisme de commande d'entraînement en rotation des pieds de cartouche avec indexation et le mécanisme de basculement de pied de cartouche sont constitués par un mécanisme unique (12).

3. Dispositif selon la revendication 1 ou 2, caractérisé en ce que ledit angle prédéterminé α entre l'axe de rotation (22) du barillet (9) et l'axe géométrique (23) longitudinal du four (1) est compris entre environ 30° et 50°.

4. Dispositif selon l'une quelconque des revendications 1 à 3, caractérisé en ce que le barillet (9) ainsi que les mécanismes (12) de commande d'entraînement en rotation et de basculement des pieds de cartouche sont placés à l'intérieur d'un conteneur hermétique (24) muni d'une ouverture latérale obturable (25).

5. Dispositif selon l'une quelconque des revendications 1 à 4, caractérisé en ce que l'axe de rotation (22) du barillet (9) est incliné dudit angle prédéterminé α par rapport à la paroi (13) d'un véhicule spatial qui est elle-même parallèle à l'axe géométrique (23) du four (1) monté de façon amovible dans un logement (14) de ladite paroi (13).

6. Dispositif selon l'une quelconque des revendications 1 à 4, caractérisé en ce que l'axe de rotation (22) du barillet (9) est parallèle à la paroi (13) d'un véhicule spatial, tandis que l'axe géométrique (23) du four (1) monté de façon amovible dans un logement (14) de ladite paroi (13) est lui-même incliné par rapport à cette paroi (13).

7. Dispositif selon l'une quelconque des revendications 1 à 6, caractérisé en ce que le barillet (9) est disposé dans un compartiment de chargement (8) muni d'un couvercle (8a) disposé du côté opposé aux pieds de cartouche (20) de manière à permettre le chargement et le déchargement de l'ensemble des cartouches (10) du côté opposé aux pieds de cartouche (20) entre deux séquences de traitement d'un jeu de cartouches (10).

8. Dispositif selon l'une quelconque des revendications 1 à 6, caractérisé en ce que le barillet (9) est disposé dans un compartiment de chargement (8) muni d'un couvercle (8a) disposé du côté des pieds de cartouche (20) de manière à permettre le chargement et le déchargement de l'ensemble des cartouches (10) à travers les pieds de cartouche (20) entre deux séquences de traitement d'un jeu de cartouches (10).

9. Dispositif selon l'une quelconque des revendications 1 à 3, caractérisé en ce que le barillet (9) est disposé dans un compartiment de chargement (8) raccordé par des brides (7) à une enceinte (2) définissant une chambre de process et contenant le four (1) ainsi que les mécanismes (12) de commande d'entraînement en rotation et de basculement des pieds de cartouche (20), de manière à permettre un échange de l'ensemble du barillet (9) entre deux séquences de traitement d'un jeu de cartouches (10).

10. Dispositif selon l'une quelconque des revendications 1 à 9, caractérisé en ce que chaque pied de cartouche (20) comprend une interface (71) essentiellement plane de positionnement mécanique et de connexion électrique adaptée pour coopérer avec une interface complémentaire unique (70) essentiellement plane de positionnement mécanique et de connexion électrique disposée sur des moyens de support desdits moyens (6) d'entraînement en translation du four (1).

11. Dispositif selon la revendication 10, caractérisé en ce que lesdites interfaces (71, 70) de positionnement mécanique et de connexion électrique comprennent des éléments de centrage complémentaires en forme de vé.

12. Dispositif selon la revendication 10 ou 11, caractérisé en ce que lesdites interfaces (71, 70) de positionnement mécanique et de connexion électrique comprennent des premiers contacts électriques (76) de forte intensité pour le passage du courant nécessaire au processus lors du traitement d'échantillons et des seconds contacts électriques (75) de faible intensité pour le passage des signaux électriques de mesure.

13. Dispositif selon l'une quelconque des revendications 1 à 12, caractérisé en ce qu'il comprend un dispositif de préchauffage (111, 113) des cartouches qui s'étend de façon statique autour d'au moins une partie du barillet cylindrique (9) de part et d'autre d'une ouverture (25) permettant le basculement d'une cartouche en position de travail (11).

14. Dispositif selon l'une quelconque des revendications 1 à 13, caractérisé en ce qu'il comprend un dispositif amortisseur de vibrations comprenant une roue centrale (45) disposée au centre du barillet (9) au voisinage des extrémités des cartouches (10) opposées aux pieds de cartouche (20) et munie d'empreintes (46) formées à sa périphérie pour recevoir les extrémités des cartouches (10) et un cerclage extérieur statique (44) qui entoure la roue centrale (45) à l'extérieur des cartouches (10) et présente une interruption pour permettre le basculement d'une cartouche en position de travail (11).

15. Dispositif selon la revendication 1 ou 2, caractérisé en ce que le mécanisme (12) de commande d'entraînement en rotation des pieds de cartouche (20) avec indexation comprend un moteur électrique (50) qui coopère avec un réducteur (52) et un dispositif à croix de Malte (53) agissant sur la partie inférieure des pieds de cartouche (20).

16. Dispositif selon la revendication 1 ou 2, caractérisé en ce que le mécanisme (12) de commande d'entraînement en rotation des pieds de cartouche (20) avec indexation comprend un moteur électrique (50, 150) qui entraîne un doigt (47, 147) de commande de rotation agissant sur des gorges (51, 151) formées dans les pieds de cartouche (20) et une came (49, 149) coopérant avec des alvéoles (48, 148) formées dans les pieds de cartouche (20) pour assurer un verrouillage à chaque indexation.

17. Dispositif selon la revendication 16, caractérisé en ce que le moteur électrique (50) présente un axe parallèle à l'axe de rotation (22) du barillet (9).

18. Dispositif selon la revendication 16, caractérisé en ce que le moteur électrique (150) présente un axe perpendiculaire et concourant à l'axe de rotation (22) du barillet (9).

19. Dispositif selon l'une quelconque des revendications 1, 2 et 15 à 18, caractérisé en ce que le mécanisme de basculement de pied de cartouche comprend une courte chaîne cinématique dérivée du mécanisme (12) de commande d'entraînement en rotation des pieds de cartouche.

20. Dispositif selon la revendication 19, caractérisé en ce que le mécanisme de basculement de pied de cartouche comprend un organe (46) formant came qui est entraîné à partir d'un moteur électrique (50, 150) constituant l'organe initiateur du mécanisme (12) de commande d'entraînement en rotation des pieds de cartouche (20), et qui coopère avec des parties supérieures profilées (220) des pieds de cartouche (20), chaque pied de cartouche (20) coopérant en outre avec un ressort de rappel (102) dans une position de repos parallèlement à l'axe de rotation (22) du barillet.

21. Dispositif selon la revendication 19, caractérisé en ce que le mécanisme de basculement de pieds de cartouche comprend un organe en forme de tiroir (54) qui coopère avec des parties supérieures profilées des pieds de cartouche (20) et présente un mouvement de va-et-vient induit par un moteur électrique (50) constituant l'organe initiateur du mécanisme (12) de commande d'entraînement en rotation des pieds de cartouche (20).

22. Dispositif selon la revendication 19, caractérisé en ce que le mécanisme de basculement de pied de cartouche comprend une genouillère (83) agissant sur les parties supérieures des pieds de cartouche (20) et coopérant avec un moteur électrique (250).

**Patentansprüche**

1. Ladevorrichtung für einen automatischen Weltraum-Behandlungsofen (1), der eine geometrische Längsachse (23) aufweist, sowie Mittel (6), um in geführter Weise den Ofen (1) längs der genannten geometrischen Längsachse (23) zur Translationsbewegung anzutreiben, wobei die Ladevorrichtung in Nachbarschaft des Ofens (1) angeordnet ist und ein kartuschentragendes Magazin (9) aufweist, das mit einer Anordnung von Kartuschenfüßen (20) ausgestattet ist, in denen entnehmbar geschlossene, dichte Kartuschen (10) angebracht sind, die dazu bestimmt sind, jeweils eine im genannten Weltraumofen (1) zu behandelnde Probe aufzunehmen, und die im Magazin (9) parallel zu dessen Drehachse (22) angeordnet sind, sowie einen Steuermechanismus (12) zum schrittweisen Drehantrieb der Kartuschenfüße,
dadurch **gekennzeichnet**, daß das Magazin (9) seinerseits bezüglich des Ofens (1) derartig angebracht ist, daß seine Drehachse (22) einen vorbestimmten Winkel $\alpha$ in bezug auf die geometrische Längsachse (23) des Ofens (1) bildet, und daß jeder Kartuschenfuß (20) des Magazins (9) mit einem Kippmechanismus zusammenwirkt, um es jeder Kartusche zu gestatten, eine Arbeitslage (11) darzubieten, in welcher die Achse der Kartusche um den genannten, vorbestimmten Winkel $\alpha$ in bezug auf die Drehachse (22) des Magazins (9) geneigt ist, um auf die geometrische Achse (23) des Ofens (1) ausgerichtet zu sein.

2. Vorrichtung nach Anspruch 1, dadurch **gekennzeichnet**, daß der Steuermechanismus zum schrittweisen Drehantrieb der Kartuschenfüße und der Kippmechanismus des Kartuschenfußes von einem einzigen Mechanismus (12) gebildet sind.

3. Vorrichtung nach Anspruch 1 oder 2, dadurch **gekennzeichnet**, daß der genannte vorbestimmte Winkel $\alpha$ zwischen der Drehachse (22) des Magazins (9) und der geometrischen Längsachse (23) des Ofens (1) zwischen etwa 30° und 50° liegt.

4. Vorrichtung nach irgendeinem der Ansprüche 1 bis 3, dadurch **gekennzeichnet**, daß das Magazin (9) ebenso wie die Steuermechanismen (12) zum Drehantrieb und zum Kippen der Kartuschenfüße im Inneren eines dichten Behälters (24) angeordnet sind, der mit einer seitlichen, verschließbaren Öffnung (25) versehen ist.

5. Behälter nach irgendeinem der Ansprüche 1 bis 4, dadurch **gekennzeichnet**, daß die Drehachse (22) des Magazins (9) um den vorbestimmten Winkel α in bezug auf die Wand (13) eines Raumfahrzeugs geneigt ist, die ihrerseits parallel zur geometrischen Achse (23) des Ofens (1) ist, der abnehmbar in einem Sitz (14) der genannten Wand (13) angebracht ist.

6. Vorrichtung nach irgendeinem der Ansprüche 1 bis 4, dadurch **gekennzeichnet**, daß die Drehachse (22) des Magazins (9) parallel zur Wand (13) eines Raumfahrzeugs angeordnet ist, während die geometrische Achse (23) des Ofens (1), der abnehmbar in einem Sitz (14) der genannten Wand (13) angebracht ist, ihrerseits in bezug auf diese Wand (13) geneigt ist.

7. Vorrichtung nach irgendeinem der Ansprüche 1 bis 6, dadurch **gekennzeichnet**, daß das Magazin (9) in einem Ladeabteil (8) angeordnet ist, das mit einem Deckel (8a) versehen ist, der auf der den Kartuschenfüßen (20) entgegengesetzten Seite derart angeordnet ist, daß er das Be- und Entladen der Kartuschenanordnung (10) von der den Kartuschenfüßen (20) entgegengesetzten Seite zwischen zwei Behandlungsfolgen eines Kartuschensatzes (10) gestattet.

8. Vorrichtung nach irgendeinem der Ansprüche 1 bis 6, dadurch **gekennzeichnet**, daß das Magazin (9) in einem Ladeabteil (8) angeordnet ist, das mit einem Deckel (8a) versehen ist, der auf der Seite der Kartuschenfüße (20) derart angeordnet ist, daß er das Be- und Entladen der Kartuschenanordnung (10) über die Kartuschenfüße (20) hinweg zwischen zwei Behandlungsfolgen eines Kartuschensatzes (10) gestattet.

9. Vorrichtung nach irgendeinem der Ansprüche 1 bis 3, dadurch **gekennzeichnet**, daß das Magazin (9) in einem Ladeabteil (8) angeordnet ist, das durch Bügel (7) mit einer Umhüllung (2) verbunden ist, die eine Prozeßkammer umgrenzt und den Ofen (1) sowie die Steuermechanismen (12) zum Drehantrieb und zum Kippen der Kartuschenfüße (20) enthält, und zwar derart, daß ein Austausch der Magazinanordnung (9) zwischen zwei Behandlungsfolgen eines Kartuschensatzes (10) gestattet ist.

10. Vorrichtung nach irgendeinem der Ansprüche 1 bis 9, dadurch **gekennzeichnet**, daß jeder Kartuschenfuß (20) eine im wesentlichen ebene Schnittstelle (71) zur mechanischen Positionierung und zum elektrischen Anschluß aufweist, die dazu eingerichtet ist, mit einer komplementären einzigen, im wesentlichen ebenen Schnittstelle (70) zur mechanischen Positionierung und zum elektrischen Anschluß zusammenzuwirken, die auf den Tragemitteln der genannten Antriebsmittel (6) für die Translationsbewegung des Ofens (1) angeordnet ist.

11. Vorrichtung nach Anspruch 10, dadurch **gekennzeichnet**, daß die genannten Schnittstellen (71, 70) zur mechanischen Positionierung und zum elektrischen Anschluß komplementäre, V-förmige Zentrierelemente aufweisen.

12. Vorrichtung nach Anspruch 10 oder 11, dadurch **gekennzeichnet**, daß die genannten Schnittstellen (71, 70) zur mechanischen Positionierung und zum elektrischen Anschluß erste elektrische Kontakte (76) hoher Intensität für den Durchtritt des Stromes aufweisen, der notwendig ist für die Prozesse während der Behandlung der Proben, sowie zweite elektrische Kontakte (75) schwacher Intensität für den Durchtritt elektrischer Meßsignale.

13. Vorrichtung nach irgendeinem der Ansprüche 1 bis 12, dadurch **gekennzeichnet**, daß sie eine Vorheizvorrichtung (111, 113) für die Kartuschen aufweist, die sich in statischer Weise rund um mindestens einen Teil des zylindrischen Magazins (9) beiderseits einer Öffnung (25) erstreckt, die das Abkippen einer Kartusche in die Arbeitslage (11) gestattet.

14. Vorrichtung nach irgendeinem der Ansprüche 1 bis 13, dadurch **gekennzeichnet**, daß sie eine Schwingungsdämpfungsvorrichtung aufweist, die ein mittiges Rad (45) aufweist, das in der Mitte des Magazins (9) in der Nähe der Enden der Kartuschen (10) angeordnet ist, die den Kartuschenfüßen (20) entgegengesetzt sind, und mit Vertiefungen (46) versehen ist, die in seinem Umfang ausgebildet sind, um die Enden der Kartuschen (10) aufzunehmen, sowie eine ruhende Umreifung (44), die das mittige Rad (45) an der Außenseite der Kartuschen (10) umrundet und eine Unterbrechung aufweist, um das Abkippen einer Kartusche in die Arbeitslage (11) zu gestatten.

15. Vorrichtung nach Anspruch 1 oder 2, dadurch **gekennzeichnet**, daß der Steuermechanismus (12) zum schrittweisen Drehantrieb der Kartuschenfüße (20) einen Elektromotor (50) aufweist, der mit einer Untersetzung (52) und einer Malteserkreuzvorrichtung (53) zusammenwirkt, die auf den unteren Teil der Kartuschenfüße (20) einwirkt.

16. Vorrichtung nach Anspruch 1 oder 2, dadurch **gekennzeichnet,** daß der Steuermechanismus (12) zum schrittweisen Drehantrieb der Kartuschenfüße (20) einen Elektromotor (50, 150) aufweist, der einen Rotations-Steuerfinger (47, 147) antreibt, der auf Auskehlungen (51, 151) einwirkt, die in den Kartuschenfüßen (20) ausgebildet sind, sowie einen Nocken (49, 149), der mit Zellen (48, 148) zusammenwirkt, die in den Kartuschenfüßen (20) ausgebildet sind, um eine Verriegelung in jeder Drehschrittstellung sicherzustellen.

17. Vorrichtung nach Anspruch 16, dadurch **gekennzeichnet**, daß der Elektromotor (50) eine Achse aufweist, die parallel ist zur Drehachse (22) des Magazins (9).

18. Vorrichtung nach Anspruch 16, dadurch **gekennzeichnet**, daß der Elektromotor (150) eine Achse aufweist, die senkrecht zur Drehachse (22) des Magazins (9) steht und auf diese trifft.

19. Vorrichtung nach irgendeinem der Ansprüche 1, 2 und 15 bis 18, dadurch **gekennzeichnet**, daß der Abkippmechanismus für den Kartuschenfuß eine kurze kinematische Kette aufweist, die vom Steuermechanismus (12) zum Drehantrieb der Kartuschenfüße abgeleitet ist.

20. Vorrichtung nach Anspruch 19, dadurch gekennzeichnet, daß der Kippmechanismus des Kartuschenfußes ein Organ (46) aufweist, das einen Nocken bildet, der von einem Elektromotor (50, 150) her angetrieben ist, der das Auslöseorgan des Steuermechanismus (12) zum Drehantrieb der Kartuschenfüße (20) bildet, und der mit höheren, profilierten Abschnitten (220) der Kartuschenfüße (20) zusammenwirkt, wobei jeder Kartuschenfuß (20) außerdem mit einer Feder (102) zur Rückstellung in eine Ruhelage parallel zur Drehachse (22) des Magazines zusammenwirkt.

21. Vorrichtung nach Anspruch 19, dadurch **gekennzeichnet**, daß der Abkippmechanismus für die Kartuschenfüße ein schieberförmiges Organ (54) aufweist, das mit höheren, profilierten Abschnitten der Kartuschenfüße (20) zusammenwirkt und eine Hin- und Herbewegung aufweist, die von einem Elektromotor (50) induziert ist, der den Anreger des Steuermechanismus (12) zum Drehantrieb der Kartuschenfüße (20) bildet.

22. Vorrichtung nach Anspruch 19, dadurch **gekennzeichnet**, daß der Abkippmechanismus für den Kartuschenfuß einen Kniehebel (83) aufweist, der auf die oberen Abschnitte der Kartuschenfüße (20) einwirkt und mit einem Elektromotor (250) zusammenwirkt.

## Claims

1. A loader device for an automatic space treatment furnace (1) having a longitudinal axis (23) and means (6) for driving the furnace (1) in guided translation along said longitudinal axis (23), the loader device being disposed in the vicinity of the furnace (1) and comprising a cartridge-carrying carousel (9) fitted with a set of cartridge holders (20) removably receiving sealed closed cartridges (10) each designed to contain a sample for treatment in said space furnace (1), the cartridges being disposed in the carousel (9) parallel to its axis of rotation (22), and a control mechanism (12) for imparting indexed rotary drive to the cartridge holders,

characterized in that the carousel (9) is itself mounted relative to the furnace (1) in such a manner that its axis of rotation (22) forms a predetermined angle α relative to the longitudinal axis (23) of the furnace (1), and in that each cartridge holder (20) of the carousel (9) co-operates with a tilting mechanism to enable each cartridge to take up a working position (11) in which the axis of the cartridge is tilted through said predetermined angle α relative to the axis of rotation (22) of the carousel (9) so as to be aligned with the axis (23) of the furnace (1).

2. A device according to claim 1, characterized in that the control mechanism for imparting indexed rotary drive to the cartridge holders and the mechanism for tilting the cartridge holders are constituted by a single mechanism (12).

3. A device according to claim 1 or 2, characterized in that said predetermined angle α between the axis of rotation (22) of the carousel (9) and the longitudinal axis (23) of the furnace (1) lies in the range about 30° to about 50°.

4. A device according to any one of claims 1 to 3, characterized in that the carousel (9) and the control mechanisms (12) for rotating and for tilting the cartridge holders are placed inside a hermetic container (24) provided with a closable side opening (25).

5. A device according to any one of claims 1 to 4, characterized in that the axis of rotation (22) of the carousel (9) is inclined at said predetermined angle α relative to the wall (13) of a space vehicle which is itself parallel to the axis (23) of the furnace (1) which is removably mounted in a housing (14) in said wall (13).

6. A device according to any one of claims 1 to 4, characterized in that the axis of rotation (22) of the carousel (9) is parallel to the wall (13) of a space vehicle, while the axis (23) of the furnace (1) that is removably mounted in a housing (14) in said wall (13) is itself inclined relative to said wall (13).

7. A device according to any one of claims 1 to 6, characterized in that the carousel (9) is disposed in a loading compartment (8) provided with a cover (8a) disposed at its end opposite from the cartridge holders (20) so as to enable all of the cartridges (10) to be loaded and unloaded through the end opposite from the cartridge holders (20) between two treatment sequences for a set of cartridges (10).

8. A device according to any one of claims 1 to 6, characterized in that the carousel (9) is disposed in a loading compartment (8) provided with a cover (8a) disposed at the same end as the cartridge holders (20) so as to enable all of the cartridges (10) to be loaded and unloaded through the cartridge holders (20) between two treatment sequences of a set of cartridges (10).

9. A device according to any one of claims 1 to 3, characterized in that the carousel (9) is disposed in a loading compartment (8) connected by flanges (7) to an enclosure (2) defining a process chamber and containing the furnace (1) together with the control mechanisms for rotating and tilting the cartridge holders (20) so as to enable the carousel assembly (9) to be exchanged between two treatment sequences of a set of cartridges (10).

10. A device according to any one of claims 1 to 9, characterized in that each cartridge holder (20) comprises an essentially plane interface (71) for mechanical positioning and for electrical connection and adapted to co-operate with a single, essentially plane complementary interface for mechanical positioning and for electrical connection disposed on means for supporting said means (6) for driving the furnace (1) in translation.

11. A device according to claim 10, characterized in that said mechanical positioning and electrical connection interfaces (71, 70) include complementary V-shaped centering elements.

12. A device according to claim 10 or 11, characterized in that said mechanical positioning and electrical connection interfaces (71, 70) include first electrical contacts (76) for passing high current required for the process during the treatment of samples, and second electrical contacts (75) for passing low current for electrical measurement signals.

13. A device according to any one of claims 1 to 12, characterized in that it includes a cartridge preheater device (111, 113) which extends in stationary manner around at least a portion of the carousel (9) on either side of an opening (25) enabling a cartridge to be tilted into the working position (11).

14. A device according to any one of claims 1 to 13, characterized in that it includes a device for damping vibration and comprising a central wheel (45) disposed in the center of the carousel (9) in the vicinity of the ends of the cartridges (10) opposite from the cartridge holders (20) and provided with depressions (46) formed in its periphery for receiving the ends of the cartridges (10), and a static outer band (44) which surrounds the central wheel (45) outside the cartridges (10) and which has a gap to enable a cartridge to be tilted into the working position (11).

15. A device according to claim 1 or 2, characterized in that the control mechanism (12) for imparting indexed rotary drive to the cartridge holders (20) comprises an electric motor (50) which co-operates with a stepdown gear mechanism (52) and a Maltese cross device (53) acting on the bottom portions of the cartridge holders (20).

16. A device according to claim 1 or 2, characterized in that the control device (12) for imparting indexed rotary drive to the cartridge holders (20) comprises an electric motor (50, 150) that drives a rotation control finger (47, 147) acting on grooves (51, 151) formed in the cartridge holders (20), and a cam (49, 149) co-operating with recesses (48, 148) formed in the cartridge holders (20) to provide locking in each indexed position.

17. A device according to claim 16, characterized in that the electric motor (50) has an axis that is parallel to the axis of rotation (22) of the carousel (9).

18. A device according claim 16, characterized in that the electric motor (150) has an axis that is perpendicular to and that intersects the axis of rotation (22) of the carousel (9).

19. A device according to any one of claims 1, 2, and 15 to 18, characterized in that the cartridge holder tilting mechanism comprises a short drive system driven by the control mechanism (12) for rotating the cartridge holders.

20. A device according to claim 19, characterized in that the cartridge holder tilting mechanism comprises a cam-forming member (46) which is driven from an electric motor (50, 150) constituting the initiator member of the control mechanism (12) for rotating the cartridge holders (20), and which co-operates with shaped upper portions (220) of the cartridge holders (20), each cartridge holder (20) also co-operating with a return spring (102) in a rest position parallel to the axis of rotation (22) of the carousel.

21. A device according to claim 19, characterized in that the cartridge holder tilting mechanism comprises a slider member (54) which co-operates with shaped upper portions of the cartridge holders (20) and which is driven with reciprocating motion by an electric motor (50) constituting the initiator member of the control mechanism (12) for rotating the cartridge holders (20).

22. A device according to claim 19, characterized in that the cartridge holder tilting mechanism includes a toggle mechanism (83) acting on the upper portions of the cartridge holders (20) and co-operating with an electric motor (250).

**FIG.2**

**FIG.1**

EP 0 600 786 B1

FIG.5

FIG.4

FIG.3

18

**FIG.7**
(Art antérieur)

**FIG.6**
(Art antérieur)

**FIG.8**

**FIG.9**

EP 0 600 786 B1

FIG.10A

FIG.10B

FIG.10C

EP 0 600 786 B1

FIG.11A

FIG.12A

FIG.11B

FIG.12B

EP 0 600 786 B1

FIG.13

**FIG.14**

**FIG.15**

FIG.16A    FIG.16B    FIG.16C

EP 0 600 786 B1

FIG.17

FIG.18

FIG.19

FIG.20

FIG.21

**FIG. 23**

**FIG. 22**

FIG.24

FIG.25

EP 0 600 786 B1

FIG.26

FIG.27

# FIG. 28

21

220

20

FIG.29

108

93

107

91

102

99

104

9

148

FIG.30A

93 91

90

91

93a

FIG.30B

94 92 9

95

FIG.31A

94 96

95

92

FIG.31B

# FIG. 32